# EUROPEAN PATENT APPLICATION

(11) **EP 4 507 320 A1**
(43) Date of publication of application: **12.02.2025**
(21) Application number: 23915203.6
(22) Date of filing: 23.08.2023
(51) Int. Cl.: H04N 25/40

(54) **IMAGE SENSOR AND READOUT CIRCUIT THEREOF**

(30) Priority: 19.06.2023 CN 202310732730; 19.06.2023 CN 202321569770 U; 19.06.2023 CN 202321569685 U; 19.06.2023 CN 202310729218
(71) Applicant: Smartsens Technology (Shanghai) Co., Limited, Shanghai 200120 (CN)
(72) Inventor: LIN, Wenlong, Shanghai, 200120 (CN); REN, Guanjing, Shanghai, 200120 (CN)
(74) Representative: De Ros, Alberto
(86) International application number: PCT/CN2023/114510
(87) International publication number: WO 2024/259802

(57) **Abstract**

The present application provides an image sensor and a readout circuit (1) of the image sensor, where the readout circuit (1) of the image sensor is composed of a ramp voltage circuit (10), a comparison circuit (20), a counter circuit (30) and an inversion control circuit (40). When switching a counting, the inversion control circuit (40) is provided to control the counter circuit (30) to invert a first digital code value into a second digital code value, so that in a second quantization time period, the counter circuit (30) is enabled to count based on the second digital code value to generate a third digital code value, thereby a correlated double sampling is realized, a fixed pattern noise is reduced and an imaging quality is improved. Also, in the readout circuit (1), a buffer or an additional holding circuit is no longer in need, thus a circuit structure is simplified, which reduces power consumption, and can ensure that the counter circuit is operated in a high-frequency counting mode.

## Description

This application claims the priority of the Chinese invention patent application No. 202310729218.X, entitled "Image Sensor and Readout Circuit Thereof", the Chinese invention patent application No. 202310732730.X, entitled "Image Sensor and Readout Circuit Thereof", the Chinese utility module patent application No. 202321569685.2, entitled "Image Sensor and Readout Circuit Thereof", and the Chinese utility module patent application No. 202321569770.9, entitled "Image Sensor and Readout Circuit Thereof", all filed with the China Patent Office on Jun. 19, 2023, the entire contents of which are incorporated herein by reference.

### TECHNICAL FIELD

The present application relates to the field of image sensor technology, and in particular, to an image sensor and a readout circuit of the image sensor.

### BACKGROUND

CMOS image sensors have the advantages of low voltage, low power consumption, low cost and high integration, and have important application value in the fields of machine vision, consumer electronics, high-definition monitoring and medical imaging. The analog-to-digital converter (Analog-to-Digital Converter, ADC) is an important component of the readout circuit of the CMOS image sensor, and is responsible for converting an analog signal output from pixels into a digital signal. Column-level ADC is generally used in the CMOS image sensor, and the common one includes a single slope ADC (SS SDC), a successive approximation ADC (SAR ADC) and a cyclic ADC (Cyclic ADC).

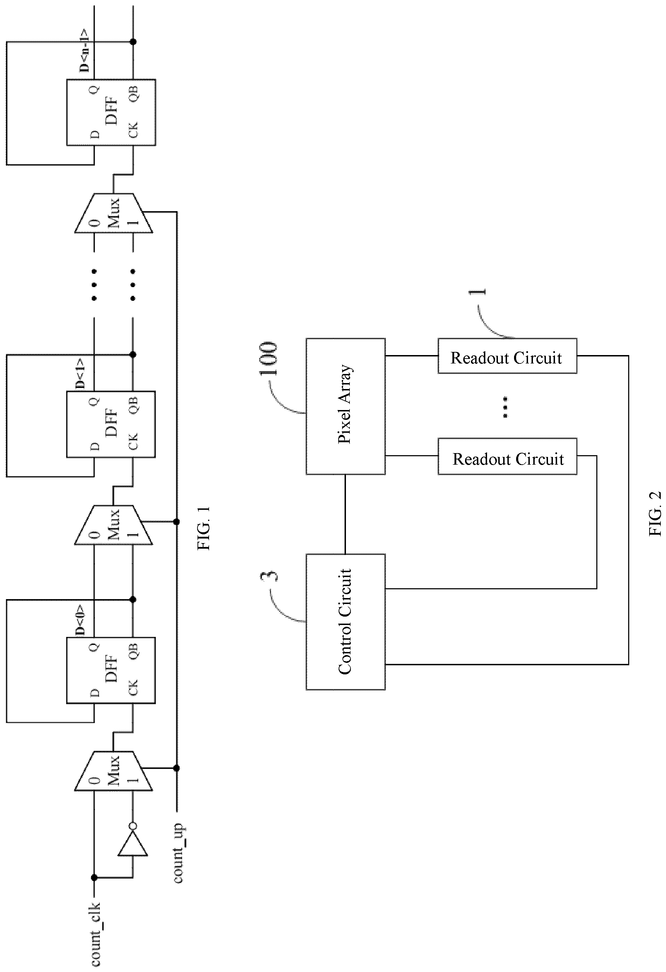

The counter in the traditional SS ADC is generally a reversible counter, that is, the switching of up/down counting can be realized by the counter. As shown in FIG. 1, the N-bit counter circuit is composed of cascaded counter units. When count_up is 1, an output signal QB from an inverting output pin of a current counter unit serves as a clock signal of a next counter unit, which is an up-counting mode; when count_up is 0, an output signal Q from a non-inverting output pin of the current counter unit serves as the clock signal of the next counter unit, which is a down-counting mode. After the two counting are stopped, a final counting result D<n-1:0> is stored in a memory.

Since the operating frequency of count_clk is very high (usually hundreds of MHz or even more than 1GHz), in the traditional reversible counter, a two-to-one data selector and a buffer for driving are required to be inserted in each counter unit, which increases power consumption. In the meantime, the structure faces the problem of keeping the first quantization result stable during the switching of up/down counting, and in this structure, an additional holding circuit is required, which renders the circuit layout being more complicated, causes the parasitic capacitance and resistance of the routing to be increased, and further causes the power consumption to be increased, and thus the maximum operating frequency of the counter is limited.

### TECHNICAL PROBLEM

An objective of the present application is to provide a readout circuit of an image sensor, aiming to solve the problems of high power consumption and complex structure of traditional reversible counters.

### TECHNICAL SOLUTIONS

To solve the above technical problems, technical schemes adopted by the embodiments of the present application are as follows:
In accordance with a first aspect of the embodiments of the present application, a readout circuit of an image sensor is provided, including: a ramp voltage circuit, a comparison circuit, a counter circuit and an inversion control circuit.

The ramp voltage circuit is configured to output a ramp voltage signal in a first quantization time period and a second quantization time period of the pixel unit respectively.

The comparison circuit has a first input end connected to a pixel unit and a second input end connected to the ramp voltage circuit, and is configured to compare a reset signal or a pixel signal output from the pixel unit with the ramp voltage signal and output a reset pulse signal or a pixel pulse signal.

The counter circuit is connected to the comparison circuit and is configured to count a first pulse signal in the first quantization time period and store a first digital code value; and in the second quantization time period, the counter circuit is configured to count a second pulse signal based on a second digital code value and store a counting result as a third digital code value, the first pulse signal and the second pulse signal are respectively the reset pulse signal and the pixel pulse signal, or first pulse signal and the second pulse signal are respectively the pixel pulse signal and the pixel pulse signal.

The inversion control circuit is connected to the counter circuit, and is configured, in response to a triggering of a mode selection signal, to output an inversion control signal between the first quantization time period and the second quantization time period, to enable the counter circuit, in response to a triggering of the inversion control signal, to invert the first digital code value to the second digital code value and store the second digital code value.

In accordance with a second aspect of the embodiments of the present application, an image sensor is provided, including a pixel array, a control circuit and a plurality of the readout circuits of the image sensor as described above, where the pixel array includes a plurality of pixel units arranged in an array.

Each of the readout circuits of the image sensor is connected to a plurality of pixel units arranged in a column, and the readout circuits of the image sensor are also respectively connected to the control circuit.

### BENEFICIAL EFFECTS

Compared with the existing technologies, embodiments of the present application have the following beneficial effects: the readout circuit of the image sensor is provided with the ramp voltage circuit, the comparison circuit, the counter circuit and the inversion control circuit. When switching a counting, the inversion control circuit is provided to control the counter circuit to invert the first digital code value to the second digital code value, so that in the second quantization time period, the counter circuit is enabled to count based on the second digital code value to generate the third digital code value, thereby the correlated double sampling is realized, the fixed pattern noise is eliminated and the imaging quality is improved. Also in the readout circuit, a buffer or an additional holding circuit is no longer in need, thus the circuit structure is simplified, which renders the power consumption to be reduced, and can ensure that the counter circuit is operated in a high-frequency counting mode.

It can be understood that, for beneficial effects of the above second aspect, references may be made to the relevant descriptions in the above first aspect, which will not be described again here.

### DESCRIPTION OF DRAWINGS

In order to illustrate the technical schemes in the embodiments of the present application more clearly, the drawings that need to be used in the description of the embodiments or the existing technologies will be briefly introduced below. Obviously, the drawings in the following description are merely some embodiments of the present application. For persons of ordinary skills in the art, other drawings may be obtained based on these drawings without exerting creative efforts.
FIG. 1 is a circuit diagram of a traditional counter circuit;
FIG. 2 is a structural diagram of an image sensor provided in Embodiment 13 of the present application;
FIG. 3 is a first circuit diagram of a pixel unit in the image sensor shown in FIG. 2;
FIG. 4 is a structural diagram of a readout circuit provided in Embodiment 1 of the present application;
FIG. 5 is a structural diagram of a readout circuit provided in Embodiment 2 of the present application;
FIG. 6 is a circuit diagram of a readout circuit provided in Embodiment 3 of the present application;
FIG. 7 is a signal timing diagram of the readout circuit provided in Embodiments 3 and 4 of the present application;
FIG. 8 is a circuit diagram of a readout circuit provided in Embodiment 4 of the present application;
FIG. 9 is a structural diagram of a readout circuit provided in Embodiment 5 of the present application;
FIG. 10 is a circuit diagram of a storage circuit in the readout circuit shown in FIG. 9;
FIG. 11 is a circuit diagram of a readout circuit provided in Embodiment 6 of the present application
FIG. 12 is a structural diagram of the readout circuit provided in Embodiment 6 of the present application;
FIG. 13 is a signal timing diagram of a readout circuit provided in Embodiment 7 of the present application;
FIG. 14 is a signal timing diagram of a readout circuit provided in Embodiment 8 of the present application;
FIG. 15 is a circuit diagram of the readout circuit provided in Embodiment 7 and Embodiment 8 of the present application;
FIG. 16 is a signal timing diagram of a readout circuit provided in Embodiment 9 of the present application;
FIG. 17 is a signal timing diagram of a readout circuit provided in Embodiment 10 of the present application;
FIG. 18 is a circuit diagram of the readout circuit provided in Embodiment 9 and Embodiment 10 of the present application;
FIG. 19 is a circuit diagram of a readout circuit provided in Embodiment 11 of the present application; and
FIG. 20 is a circuit diagram of a D flip-flop in the readout circuit provided in an embodiment of the present application.

### DETAILED DESCRIPTION OF EMBODIMENTS

In order to make the technical problems to be solved, the technical schemes and the beneficial effects of the present application much clearer, the present application is further described in detail in conjunction with the accompanying drawings and embodiments. It should be understood that the specific embodiments described herein are intended only to interpret the present application, and are not intended to limit the present application.

In addition, the terms "first" and "second" are used only for descriptive purposes and cannot be understood as indicating or implying relative importance or implicitly indicating the number of technical features indicated. Therefore, the features defined as "first" and "second" may explicitly or implicitly include one or more of the features. In the description of the present application, the phrase "a/the plurality of" means two or more, unless otherwise clearly and specifically defined.

### Embodiment 1

In the first aspect of the embodiments of the present application, a readout circuit of an image sensor is provided. As shown in FIG. 2, the image sensor generally includes a control circuit 3, a pixel array 100, readout circuits 1, and may also include a clock generator and a digital I/O port. The pixel array 100 includes a plurality of pixel units arranged in an array, and a plurality of pixel units arranged in a column are connected in common. The control circuit 3 is configured to select each row of pixel units through a row selection signal, and output pixel signals of all rows to the readout circuits 1 in sequence. The plurality of pixel units arranged in one column are connected to a corresponding readout circuit 1. Each readout circuit 1 is configured to perform an analog-to-digital conversion and output a corresponding digital code value to the control circuit 3, so that the control circuit 3 is enabled to determine image information according to the digital code values.

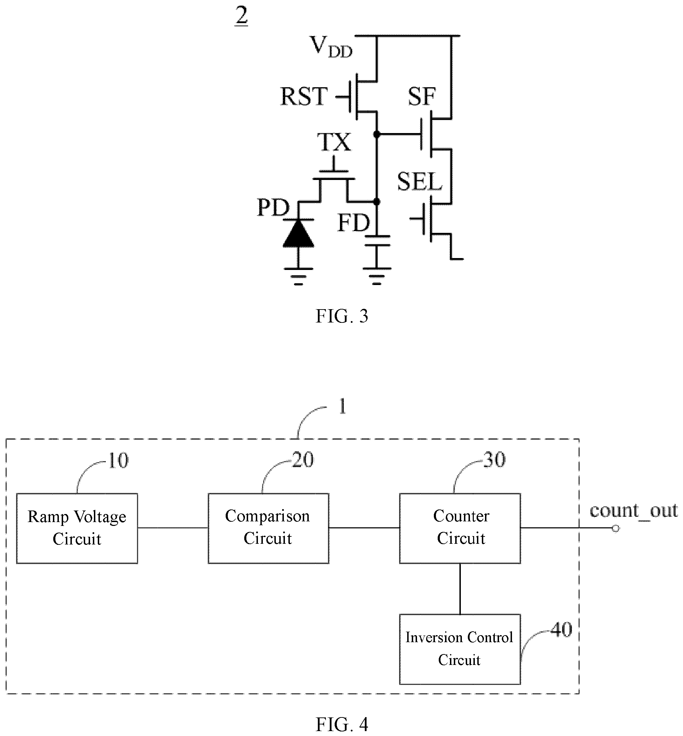

Herein, the pixel unit generally includes a photoelectric conversion element, a transmission transistor TX, a reset transistor RST, a source follower transistor SF and a row selection transistor SEL, among them, the photoelectric conversion element includes but is not limited to a photodiode PD, such as a Pin-type photodiode PD, and at the same time, the number of the photoelectric conversion element, the transmission transistor TX, the reset transistor RST, the source follower transistor SF and the row selection transistor SEL may be one or more, that is, the structure of the pixel unit can be selected based on actual needs, and the specific structure is not limited in here. As shown in FIG. 3, taking the basic pixel unit 2 as an example, the pixel unit 2 includes a photodiode PD, a transmission transistor TX, a reset transistor RST, a source follower transistor SF and a row selection transistor SEL, where a cathode of the photodiode PD is connected to a first end of the transfer transistor TX; a second end of the transfer transistor TX, a first end of the reset transistor RST and a controlled end of the source follower transistor SF are all coupled to a floating diffusion node; an anode of the photodiode PD is grounded; a second end of the reset transistor RST and a first end of the source follower transistor SF are both connected to a positive power supply VDD; a second end of the source follower transistor SF is connected to a first end of the row selection transistor SEL; and a second end of the row selection transistor SEL constitutes an output end of the pixel unit 2 and is configured to output a corresponding pixel signal.

The CMOS image sensor using the readout circuit 1 in line arrangement will face a problem of fixed pattern noise FPN, this is because threshold voltages of the transistors of each column of pixels have a certain degree of mismatch due to factors such as process and temperature. Under the same illumination condition, the mismatch will result in a poor column consistency of the pixel output signal. The 4T active pixel structure shown in FIG. 3 may be adopted to perform a correlated double sampling (Correlated Double Sampling, CDS) operation, read out a reset signal and an exposure signal of the pixels respectively, and then subtract the reset signal from the exposure signal. Since the two signals contain the same fixed pattern noise (FPN), FPN can be eliminated by performing the subtraction to improve the imaging quality.

The common CDS operation is to use two ramp signals in the SS ADC to quantize the reset signal and exposure signal of the pixels twice, and control the counter circuit to count down and up during the two quantizations, so that the subtraction is performed on analog voltage values of the pixel outputs in the digital domain. Thus, the counter circuit in this structure is a reversible counter, that is, the switching of up-counting and down-counting can be realized by the counter circuit. As shown in FIG. 1, the N-bit counter circuit is composed of cascaded counter units. When count_up is 1, an output signal QB from an inverting output pin of a current counter unit serves as a clock signal of a next counter unit, which is an up-counting mode; when count_up is 0, an output signal Q from a non-inverting output pin of the current counter unit serves as the clock signal of the next counter unit, which is a down-counting mode. After the two counting are stopped, a final counting result D<n-1:0> is stored in a memory.

Since an operating frequency of count_clk is very high (usually hundreds of MHz or even more than 1GHz), the traditional reversible counter needs to insert a two-to-one data selector MUX1 and a buffer for driving in each counter unit, which increases power consumption. In the meantime, the structure faces a problem of keeping the first quantization result stable during a switching of up/down counting, and in this structure, an additional holding circuit is required, which renders the circuit layout being more complicated, causes the parasitic capacitance and resistance of the routing to be increased, and further causes the power consumption to be increased, and thus the maximum operating frequency of the counter is limited.

In order to solve the above technical problems, as shown in FIG. 4, in this embodiment, the readout circuit 1 of the image sensor includes: a ramp voltage circuit 10, a comparison circuit 20, a counter circuit 30 and an inversion control circuit 40.

The ramp voltage circuit 10 is configured to output a ramp voltage signal in a first quantization time period and a second quantization time period of a pixel unit respectively.

The comparison circuit 20 has a first input end connected to the pixel unit and a second input end connected to the ramp voltage circuit 10, and is configured to compare a reset signal or pixel signal output from the pixel unit with the ramp voltage signal and output a reset pulse signal or a pixel pulse signal.

The counter circuit 30 is connected to the comparison circuit 20, and is configured to count a first pulse signal in the first quantization time period and store a first digital code value; and in the second quantization time period, the counter circuit 30 is configured to count a second pulse signal based on a second digital code value and store a counting result as a third digital code value, the first pulse signal is the reset pulse signal (or the pixel pulse signal) and the second pulse signal is the pixel pulse signal (or the reset pulse signal).

The inversion control circuit 40 is connected to the counter circuit 30, and is configured, in response to a triggering of a mode selection signal mode_sel, to output an inversion control signal trig_pulse between the first quantization time period and the second quantization time period, to enable the counter circuit 30, in response to a triggering of the inversion control signal trig_pulse to invert the first digital code value to the second digital code value and store the same.

In this embodiment, two ramp voltage signals are generated by the ramp voltage circuit 10 in the first quantization time period and the second quantization time period respectively, and the slopes and gains of the two ramp voltage signals may be the same or different.

The ramp voltage signal of the corresponding time period is output to the comparison circuit 20. The reset signal or pixel signal of the pixel unit in the corresponding time period is received by the comparison circuit 20. By the comparison circuit, the reset signal and the pixel signal are compared with the ramp voltage signal respectively. The reset signal and the ramp voltage signal are compared in the first quantization time period or the second quantization time period to generate the reset pulse signal. The pixel signal and the ramp voltage signal are compared in the other quantization time period to generate the pixel pulse signal.

The counter circuit 30 is configured to count up or down the reset pulse signal or the pixel pulse signal in the first quantization time period. At the end of the first quantization time period, the first digital code value of this quantization is generated and stored by the counter circuit 30. Among them, the counter circuit 30 has the function of reverse-writing, that is, the digital code value stored in the counter circuit is inverted according to the inversion control signal trig_pulse, for example, the first digital code value 0100 is inverted to generate 1011.

Between the two quantization time periods, the inversion control circuit 40, upon receiving the mode selection signal mode_sel, is triggered accordingly to output the inversion control signal trig_pulse. The counter circuit 30 is configured to invert the first digital code value stored in the counter circuit according to the received inversion control signal trig_pulse, to generate a second digital code value, the second digital code value is served as an initial state of the second quantization, that is, as a basic value of the counter circuit 30 in the second counting.

At an initial moment of the second quantization time period, the status of mode selection signal mode_sel is switched, the counter circuit 30 is restored to a counting mode and configured to perform a quantization on the second pulse signal in the second quantization time period. The counter circuit 30 is configured to count up or down based on the second digital code value, and when the output of the comparison circuit 20 is flipped, the counter circuit 30 stops counting, and the second quantization is ended.

Since the second quantization is counted on the basis of an inverted digital code value of the first quantization result, this is equivalent to performing a subtraction operation on the two digital code values. For example, the first quantization result is a reset signal, the inverted reset signal is -Vrst, and the second quantization result for the pixel signal is -Vrst+Vsig. Since the two signals contain the same FPN, the FPN can be eliminated by subtracting, thereby the imaging quality is improved.

In the meantime, by adopting the inversion counting, the counter circuit 30 does not need to switch between up-counting and down-counting, nor does the counter circuit 30 need to be provided with an additional holding circuit. The counter circuit 30 only needs to add a corresponding inversion control circuit 40. Compared with the traditional counter circuit 30, the number of transistors can be reduced, thereby the layout area is reduced and the routing is optimized, and thus the purpose of reducing power consumption can be achieved.

Among them, the ramp voltage circuit 10 may adopt the corresponding signal source, voltage generating circuit, etc., such as the ramp generator shown in FIG. 2, and the comparison circuit 20 may adopt a comparator or other configurations. Optionally, as shown in FIG. 2, the comparison circuit 20 includes a first capacitor, a second capacitor and a comparator. A first end of the first capacitor is connected to a signal pin of the ramp generating circuit, and a first end of the second capacitor is configured for an input of the reset signal or pixel signal output from the pixel unit. A second end of the first capacitor is connected to a positive input end of the comparator, and a second end of the second capacitor is connected to an inverting input end of the comparator. When the ramp voltage signal is less than the corresponding reset signal or pixel signal, the comparator outputs a low level, and the counter circuit 30 starts counting. When the ramp voltage signal is greater than the corresponding reset signal or pixel signal, the comparator outputs a high level, and the counter circuit 30 stops counting. At this time, the counting result is the digital code value after the signal quantization.

The sequence for quantization of the reset pulse signal and the pixel pulse signal may be set based on requirements. The reset pulse signal may be quantized first and then the pixel pulse signal, or alternatively, the pixel pulse signal may be quantized first and then the reset pulse signal. Optionally, the counter circuit 30 is configured to count the reset pulse signal in the first quantization time period and store the first digital code value, and count the pixel pulse signal based on the second digital code value in the second quantization time period and store the counting result as the third digital code value.

Or alternatively, the counter circuit 30 is configured to count the pixel pulse signal in the first quantization time period and store the first digital code value, and count the reset pulse signal based on the second digital code value in the second quantization time period and store the counting result as the third digital code value.

In case that the reset pulse signal is quantized first and the pixel pulse signal is quantized later, then in the first quantization time period, the reset pulse signal is quantized by the counter circuit 30 first, and by the quantization of the counter circuit 30, a first digital code value, such as Vrst, is generated. Between the two quantization time periods, the inversion control signal trig_pulse is received by the counter circuit 30, and the first digital code value corresponding to the reset pulse signal is inverted by the the counter circuit 30 to a second digital code value, that is, -Vrst is generated. In the second quantization time period, the pixel pulse signal is quantized, where a counting is performed by the counter circuit 30 based on the second digital code value, and a third digital code value is generated, i.e., -Vrst+Vsig. Since the two signals contain the same FPN, the FPN can be eliminated by performing the subtraction, and then the imaging quality is improved.

Or alternatively, in case that the pixel pulse signal is quantized first and the reset pulse signal is quantized later, then in the first quantization time period, the pixel pulse signal is quantized by the counter circuit 30 first, and by the quantization of the counter circuit 30, a first digital code value, such as Vsig, is generated. Between the two quantization time periods, the inversion control signal trig_pulse is received by the counter circuit 30, and the first digital code value corresponding to the pixel pulse signal is inverted by the counter circuit 30 to a second digital code value, that is, -Vsig is generated. In the second quantization time period, the pixel pulse signal is quantized, where a counting of the counter circuit 30 is performed based on the second digital code value, and a third digital code value is generated, i.e., -Vsig+Vrst. Since the two signals contain the same FPN, the FPN can be eliminated by performing the subtraction, and then the imaging quality is improved.

The counter circuit 30 may adopt a corresponding D flip-flop DFF, a latch or other configurations, and the inversion control circuit 40 may adopt a signal source, a selection circuit, and the like.

Compared with the existing technologies, the embodiments of the present application have the following beneficial effects: the readout circuit 1 of the above-mentioned image sensor is provided with a ramp voltage circuit 10, a comparison circuit 20, a counter circuit 30 and an inversion control circuit 40. The inversion control circuit 40 is provided to control the counter circuit 30 to invert the first digital code value into the second digital code value when switching the counting, so that in the second quantization time period, the counting of the counter circuit 30 is performed based on the second digital code value, and the third digital code value is generated, thereby the correlated double sampling is realized, the fixed pattern noise is eliminated, and the imaging quality is improved. In addition, in the readout circuit 1, neither a buffer not an additional holding circuit is needed, thus the circuit structure is simplified, the power consumption is reduced, which then can ensure that the counter circuit 30 is operated in a high-frequency counting mode.

### Embodiment 2

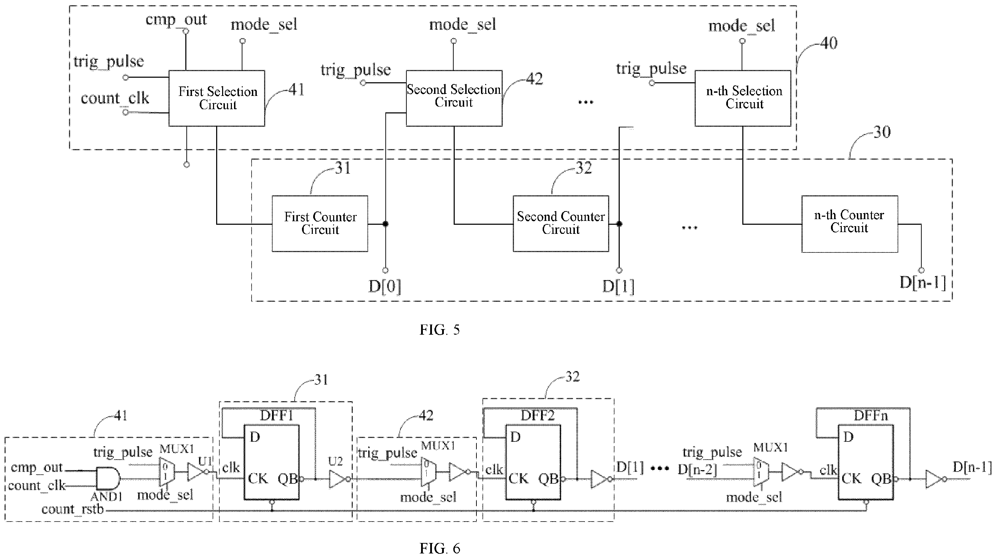

Optimization and concretization on the basis of Embodiment 1. As shown in FIG. 5, optionally, the counter circuit 30 includes a first counter unit 31 to an n-th counter unit;

The inversion control circuit 40 includes n selection circuits, a first input end of an i-th selection circuit is configured for an input of an inversion control signal trig_pulse. A second input end of the first selection circuit 41 is configured for an input of a clock signal count_clk, a third input end of the first selection circuit 41 is configured for an input of an output signal cmp_out of the comparator. Second input ends of a second selection circuit 42 to the n-th selection circuit are respectively connected to an output end of an (i-1)-th counter unit. An output end of the i-th selection circuit is connected to an input end of the i-th counter unit, where i is 1, 2, ..., n.

The i-th selection circuit is configured to output the inversion control signal trig_pulse or the clock signal count_clk in response to the mode selection signal mode_sel.

In the first quantization time period, the first counter unit 31 to the n-th counter unit are respectively configured to count the first pulse signal and store a first count value in the respective counter unit, and count values of all counter units are combined to generate the first digital code value. Between the first quantization time period and the second quantization time period, the first counter unit 31 to the n-th counter unit, upon receiving the inversion control signal trig_pulse, are respectively configured to invert the respective first count value to a second count value and store the same, and the count values of all counter units are combined to generate the second digital code value.

In the second quantization time period, the first counter unit 31 to the n-th counter unit are respectively configured to count the second pulse signal based on the respective second count value and store the respective counting result as the third count value, and the count values of all counter units are combined to generate the third digital code value.

In this embodiment, taking that the first quantization is performed on the reset pulse signal and the second quantization is performed on the pixel pulse signal as an example, each selection circuit is connected to a front end of a counter unit, and configured to output a corresponding signal of the signal input end to its own output end according to the received mode selection signal mode_sel. Before quantization, each counter unit is reset, and in the first quantization time period, a reset signal output from the pixel unit is transmitted to the comparison circuit 20. The comparison circuit 20 is configured to compare the reset signal with the ramp voltage signal and generate a reset pulse signal. The reset pulse signal is output to the first selection circuit 41, then the mode selection signal mode_sel of a first level is received by each selection circuit, and a connection between the second input end and the output end of each selection circuit is triggered. The first selection circuit 41 is configured to output the clock signal count_clk to the first counter unit 31. The subsequent selection circuit is configured to select and output a count value of a previous counter unit to a next counter unit. The first count values of all counter units are respectively stored by the respective counter unit, and the first count values of all the counter units are combined to generate the first digital code value.

Between the first quantization time period and the second quantization time period, the mode selection signal mode_sel is switched to a second level, and each selection circuit is configured to output the inversion control signal trig_pulse at the first input end to the counter unit at a back end. Each counter unit, after switched to the inversion mode, is configured to invert the first count value stored in itself to the second count value. The second count values stored in all counter units are combined to generate the second digital code value. Then, the mode selection signal mode_sel is switched to the first level again, meanwhile, a level state of the inversion control signal trig_pulse is also switched, and then each counter unit is switched to the counting mode.

In the second quantization time period, each selection circuit is configured to trigger the output clock signal count_clk to the counter unit at the back end according to the received mode selection signal mode_sel of the first level. Each counter unit is configured to count the second pulse signal based on the second count value and stores the counting result as the third count value. The count values of all counter units are combined to generate the third digital code value and then the third digital code value is read out accordingly. At this point, a complete quantization cycle is completed, and finally the third digital code value based on the subtraction operation on the reset signal and the pixel signal is obtained, which eliminates the fixed pattern noise and improves the imaging quality.

Herein, the selection circuit may select a corresponding switch structure, a selector, etc., and the counter unit may select a corresponding trigger, a latch, or other structures.

### Embodiment 3

Optimization and concretization on the basis of Embodiment 2. In an optional embodiment, as shown in FIG. 6, the first selection circuit 41 includes an AND gate AND1, a two-to-one data selector MUX1 and a first inverter U1.

A first input end of the AND gate AND1 is configured for an input of the clock signal count_clk, a second input end of the AND gate AND1 is configured for an input of the output signal cmp_out of the comparator, a first input end of the two-to-one data selector MUX1 is configured for an input of the inversion control signal trig_pulse, an output end of the AND gate AND1 is connected to a second input end of the two-to-one data selector MUX1, and an output end of the two-to-one data selector MUX1 is connected to an input end of the first inverter U1 is connected, and an output end of the first inverter U1 constitutes an output end of the first selection circuit 41.

The second selection circuit 42 to the n-th selection circuit each includes a two-to-one data selector MUX1 and a first inverter U1. From the second selection circuit 42 to the n-th selection circuit, a first input end of each two-to-one data selector MUX1 is configured for an input of the inversion control signal trig_pulse, a second input end of each two-to-one data selector MUX1 is configured for an input of a value output from a previous counter unit, an output end of each two-to-one data selector MUX1 is connected to an input end of the corresponding first inverter U1, and the output end of each first inverter U1 constitutes an output end of the corresponding selection circuit.

The counter units each includes a D flip-flop DFF and a second inverter U2.

A clock signal count_clk pin of the D flip-flop DFF of the i-th counter unit is connected to a signal output end of the i-th selection circuit, an inverting output pin of the D flip-flop DFF of the i-th counter unit is connected to an input end of the second inverter U2 and a data input pin of the D flip-flop DFF, and an output end of the second inverter U2 is connected to a second input end of the (i+1)-th selection circuit.

In this embodiment, the inverting output pin of the D flip-flop DFF is connected to the first inverter U1, and the output end of the first inverter U1 serves as a counting output end of the counter unit to realize up counting.

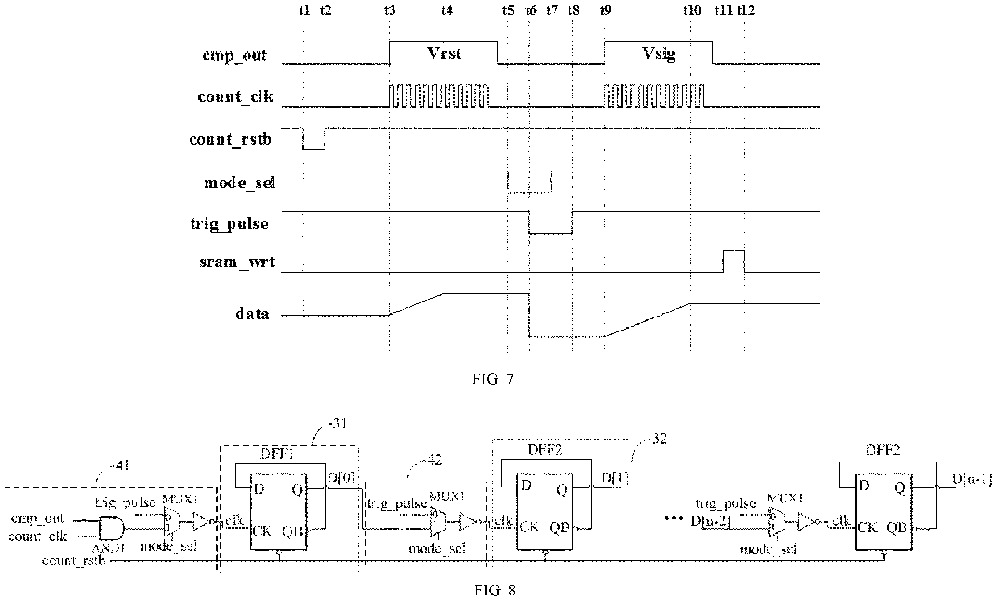

Referring to FIGS. 6 and 7, before quantization, at time t1-t2, count_rst is switched to a low level, and values in all D flip-flops DFF are reset (all outputs become 0).

At time t3, the first quantization starts, at this time, the output signal cmp_out of the comparator is switched to a high level. After the clock signal count_clk and the high level are operated via the AND gate AND1, the clock signal count_clk is output to the second input of the two-to-one data selector MUX1. At this time, the mode selection signal mode_sel is at a high level, and the clock signal count_clk is selected to be output to the first inverter U1 and output to the D flip-flop DFF. The D flip-flop DFF is controlled to count up under the action of the clock signal count_clk.

At time t4, the output of the comparison circuit 20 is flipped, the counting stops, and the first quantization is ended. Each count value of the first quantization result is stored in the corresponding D flip-flop DFF, and the first count values output from all second inverters U2 are combined to generate the first digital code value.

At time t5, the mode selection signal mode_sel is switched to a low level, and each counter unit is switched to the inversion mode.

At time t6, the inversion control signal trig_pulse is switched to a low level, and is selected and output to the first inverter U1 via the two-to-one data selector MUX1, and a rising edge is generated at a clock input of the D flip-flop DFF, and the count values of the first quantization result stored in the D flip-flops DFF are inverted as an initial state before the second quantization. The second count values output from all second inverters U2 are combined to generate the second digital code value.

At time t7, the mode selection signal mode_sel is switched to a high level, and the counter unit is restored to the counting mode. At time t8, the inversion control signal trig_pulse is switched to a high level.

At time t9, the second quantization of the pixel pulse signal starts from the initial state. At t10, the output of the comparison circuit 20 is flipped, the counting stops, and the second quantization is ended. At time t11-t12, the final quantization result is stored in the corresponding storage module and then read out. At this point, a complete quantization cycle is completed, and the digital code value based on a subtraction on the reset signal and an exposure signal of the pixel is finally obtained.

### Embodiment 4

Optimization and concretization on the basis of Embodiment 2. In another optional embodiment, as shown in FIG. 8, the first selection circuit 41 includes an AND gate AND1, a two-to-one data selector MUX1 and a first inverter U1.

A first input end of the AND gate AND1 is configured for an input of the clock signal count_clk, a second input end of the AND gate AND1 is configured for an input of the output signal cmp_out of the comparator, a first input end of the two-to-one data selector MUX1 is configured for an input of the inversion control signal trig_pulse, an output end of the AND gate AND1 is connected to a second input end of the two-to-one data selector MUX1, and an output end of the two-to-one data selector MUX1 is connected to an input end of the first inverter U1, and an output end of the first inverter U1 constitutes an output end of the first selection circuit 41.

The second selection circuit 42 to the n-th selection circuit each includes a two-to-one data selector MUX1 and a first inverter U1. From the second selection circuit 42 to the n-th selection circuit, a first input end of each two-to-one data selector MUX1 is configured for an input of the inversion control signal trig_pulse, and a second input end of each two-to-one data selector MUX1 is configured for an input of a value output from a previous counter unit, an output end of each two-to-one data selector MUX1 is connected to an input end of a corresponding first inverter U1, and the output end of each first inverter U1 constitutes an output end of the corresponding selection circuit.

Optionally, the counter unit includes a D flip-flop DFF.

A clock signal count_clk pin of the D flip-flop DFF of the i-th counter unit is connected to a signal output end of the i-th selection circuit, an inverting output pin of the D flip-flop DFF of the i-th counter unit is connected to a data input pin of the D flip-flop DFF, and a non-inverting output pin of the D flip-flop DFF is connected to a second input end of the (i+1)-th selection circuit.

In this embodiment, the non-inverting output pin of the D flip-flop DFF is served as a counting output end of the counter unit to realize down counting.

Referring to FIGS. 7 and 8, before quantization, at time t1-t2, count_rst is switched to a low level, and values in all D flip-flops DFF are reset (all outputs become 0).

At time t3, the first quantization starts, at this time, the output signal cmp_out of the comparator is switched to a high level. After the clock signal count_clk and the high level are operated via the AND gate AND1, the clock signal count_clk is output to the second input end of the two-to-one data selector MUX1. At this time, the mode selection signal mode_sel is at a high level, and the clock signal count_clk is selected to be output to the first inverter U1 and output to the D flip-flop DFF. The D flip-flop DFF is controlled to count down under the action of the clock signal count_clk.

At time t4, the output of the comparison circuit 20 is flipped, the counting stops, and the first quantization is ended. Each count value of the first quantization result is stored in the corresponding D flip-flop DFF, and the first count values output from all D flip-flops DFF are combined to generate the first digital code value.

At time t5, the mode selection signal mode_sel is switched to a low level, and each counter unit is switched to the inversion mode.

At time t6, the inversion control signal trig_pulse is switched to a low level, and is selected and output to the first inverter U1 via the two-to-one data selector MUX1, and a rising edge is generated at a clock input of the D flip-flop DFF, and each count value of the first quantization result stored in the corresponding D flip-flop DFF is inverted, as the initial state before the second quantization, and the second count values output from all D flip-flops DFF are combined to generate the second digital code value.

At time t7, the mode selection signal mode_sel is switched to a high level, and the counter unit is restored to the counting mode. At time t8, the inversion control signal trig_pulse is switched to a high level.

At time t9, the second quantization of the pixel pulse signal starts from the initial state. At time t10, the output of the comparison circuit 20 is flipped, the counting stops, and the second quantization is ended. At time t11-t12, the final quantization result is stored in the corresponding storage module and then read out. At this point, a complete quantization cycle is completed, and the digital code value based on the subtraction on the reset signal and exposure signal of the pixel is finally obtained.

### Embodiment 5

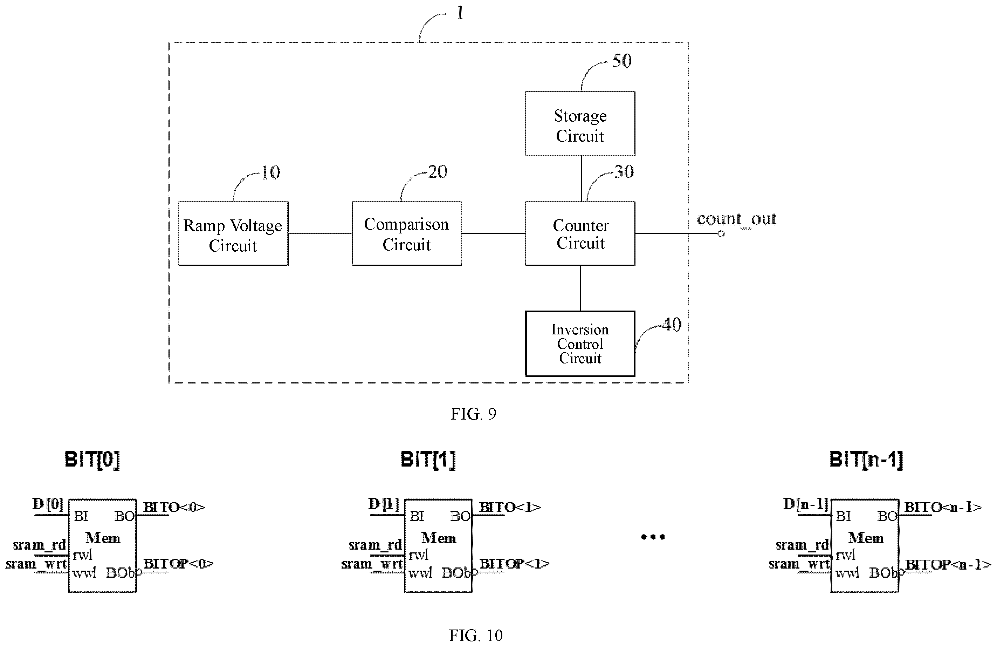

Optimization and concretization on the basis of Embodiment 1. As shown in FIG. 9, optionally, the readout circuit 1 of the image sensor also includes a storage circuit 50.

The storage circuit 50 is connected to the counter circuit 30 and configured to store the third digital code value and to read out the third digital code value in response to a triggering of a readout control signal.

In this embodiment, after the second quantization is ended, a difference between the digital code values corresponding to the reset pulse signal and the pixel pulse signal, that is, the third digital code value is obtained by the counter circuit 30. Referring to FIG. 7, at the time t11-t12, a write-in signal output to the storage circuit 50 is enabled to be high level, and the final quantization result is written into and stored in the storage circuit 50, and then read out. At this point, a complete quantization cycle is completed, and the digital code value based on the subtraction on the reset signal and exposure signal of the pixel is finally obtained.

Herein, the storage circuit 50 may select a single memory Mem or multiple memories Mem. In case that a single memory Mem is selected, then the memory Mem is provided with multiple storage partitions, each storage partition stores a third count value, and the multiple third count values are combined to generate the third digital code value. In case that multiple memories Mem are selected, then each memory Mem stores a third count value.

In an optional embodiment, as shown in FIG. 10, the storage circuit 50 includes n memories Mem.

The n memories Mem are respectively connected to the n counter units, and configured to respectively store a count value of a corresponding bit of the third digital code value.

In this embodiment, the storage circuit 50 is composed of multiple memories Mem each stores a third count value, and to simplify the structure, optionally, the memory Mem in this case has a storage of 1 bit.

### Embodiment 6

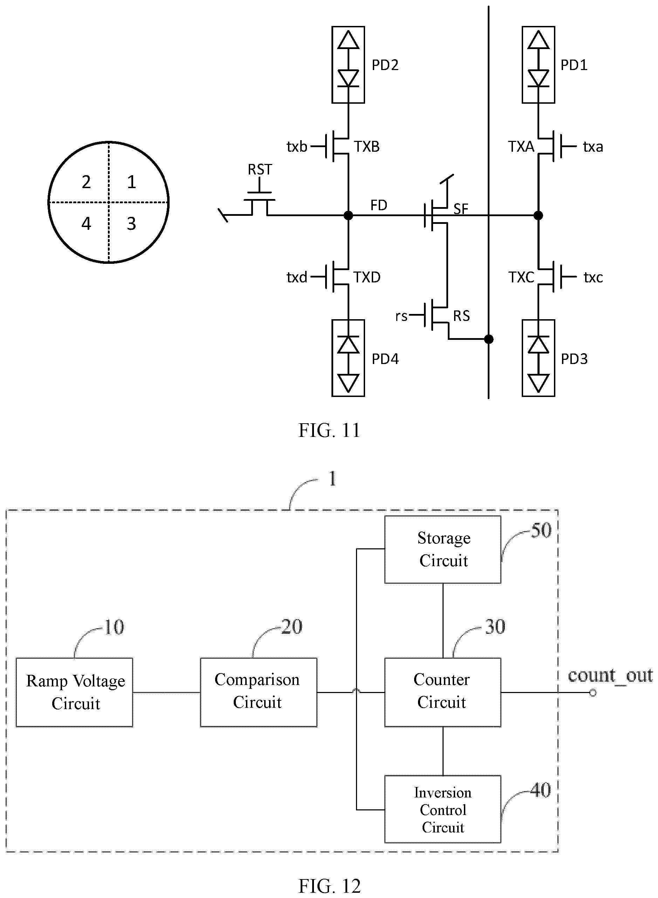

All direction auto focus (All Direction Auto Focus, ADAF) plays an important role in image sensors. As shown in the pixel array of FIG. 11, 4 pixels are arranged in a 2×2 manner, sharing a floating diffusion node and a source follower transistor. When reading out, txa and txc are switched on first, and the two pixel signals on the right are read out to obtain a piece of right phase information; then txb and txd are switched on, and the two pixel signals on the left are read out to obtain a piece of left phase information. Through the two pieces of phase information, a phase difference can be calculated, so as to perform autofocus.

Secondly, a dynamic range is a key factor in the imaging quality of the image sensor. Dual conversion gain (Dual Conversion Gain, DCG) is applied to the pixel circuit of the image sensor. Under low illumination conditions, the conversion gain is increased by using a smaller integral capacitor to improve the sensitivity; and under high illumination conditions, the storage charge is increased by using a larger integral capacitor, and the conversion gain is reduced to improve the dynamic range.

The correlated double sampling technology (CDS) can eliminate the thermal noise and part of the fixed pattern noise caused by resets of the pixels, which can greatly improve the noise performance of the image sensor. The CDS technology needs to read out the reset signal and exposure signal of the pixel separately, and then perform a subtraction on the two signals. Thus, when CDS technology is applied in a four-phase pixel structure or a dual conversion gain technology, two sets of readout circuits are required for one column of pixels, one set of the readout circuits is used to quantize the reset signal and the right pixel signal or the high-gain pulse signal, and the other set the readout circuits is used to quantize the reset signal and the left pixel signal or the low-gain pulse signal. In this way, the structural complexity and power consumption of the image sensor are increased.

Herein, the pixel unit usually has at least one sub-pixel. For example, the pixel unit shown in FIG. 11 includes at least four sub-pixels arranged in a 2×2 manner, where at least two sub-pixels constitute a pixel group and are controlled to output a reset signal or a pixel signal at the same time. The sub-pixels in the pixel unit may be grouped in pairs or in other combinations. The specific grouping manner will not be limited here.

In case that the pixel unit includes at least four sub-pixels arranged in a 2×2 manner, the four sub-pixels share a floating diffusion node FD and a source follower transistor. When reading out, txa and txc are switched on first, and the two pixel signals on the right are read out to obtain a piece of right phase information; then txb and txd are switched on, and the two pixel signals on the left are read out to obtain a piece of left phase information. (Or alternatively, txa and txb are switched on first, the upper two pixel signals are read out, and a piece of upper phase information is obtained; then txc and txd are switched on, the lower two pixel signals are read out, and a piece of lower phase information is obtained). Through the two pieces of phase information, the phase difference can be calculated, so as to perform autofocus.

To simplify the structure of the image sensor as well as the readout circuit 1 of the image sensor and to reduce the power consumption, in this embodiment, the first quantization time period is a reset sampling time period, the second quantization time period is a first exposure sampling time period, and in this case, at least one reset sampling time period and two pixel signals are provided.

The ramp voltage circuit 10 is also configured to output a ramp voltage signal in each sampling time period.

The comparison circuit 20 is also configured to compare the at least one reset signal or the two pixel signals output from the pixel unit with the ramp voltage signal, and output at least one reset pulse signal and two pixel pulse signals at intervals.

The counter circuit 30 is also configured to count at least one reset pulse signal in the at least one reset sampling time period, and store at least one counting result as at least one first digital code value; count a first pixel pulse signal based on a second digital code value in the first exposure sampling time period, and store a counting result as a third digital code value; and count a second pixel pulse signal based on a fourth digital code value and store a counting result as a fifth digital code value in the second exposure sampling time period.

The inversion control circuit 40 is connected to the counter circuit 30 and the storage circuit 50, Before each exposure sampling time period, the inversion control circuit 40 is configured, in response to a triggering of the mode selection signal mode_sel, to output the inversion control signal trig_pulse to the counter circuit 30 to trigger the counter circuit 30 to invert the stored first digital code value to generate the second digital code value or the fourth digital code value.

As shown in FIG. 12, the readout circuit of the image sensor also includes a storage circuit 50.

The storage circuit 50 is connected to the counter circuit 30 and is configured to store at least one first digital code value, and before the second exposure sampling time period, the storage circuit 50 is also configured, in response to a triggering of a write-back control signal rewrite_en, to write back one of the at least one first digital code value to the counter circuit 30.

In this embodiment, the ramp voltage signal output from the ramp voltage circuit 10 during the reset sampling time period and the exposure sampling time period may be the same or different, and the specific value(s) is(are) set according to the voltage amplitude(s) of the reset signal and the pixel signal.

Herein, one or more reset signals may be provided, and correspondingly, one or more reset sampling time periods may be included. In case that one reset signal is provided, then in the reset sampling time period, the comparison circuit 20 is configured to compare the reset signal with the reset ramp voltage signal and generate a reset pulse signal. The reset pulse signal is input to the counter circuit 30. The counter circuit 30 is configured to count the reset pulse signal up or down, and when the output of the comparison circuit 20 is flipped, the counter circuit 30 stops counting, the quantization of the reset signal is ended, where a first digital code value generated based on the counting of the counter circuit 30 is stored in the the counter circuit 30 and written by the the counter circuit 30 into the storage circuit 50.

Before the first exposure sampling time period, the inversion control circuit 40, upon receiving the mode selection signal mode_sel, is configured to output the inversion control signal trig_pulse to the counter circuit 30, the counter circuit 30 is then switched to the inversion mode and configured to invert the stored first digital code value to a second digital code value as an initial state of the first exposure sampling time period. Then, the counter circuit 30 is restored to the counting mode, and in the first exposure sampling time period, the comparison circuit 20 is configured to compare the first pixel signal with the pixel ramp voltage signal and generate a first pixel pulse signal. The first pixel pulse signal is output to the counter circuit 30. The counter circuit 30 is configured to count the first pixel pulse signal in the same direction based on the second digital code value, and when the output of the comparison circuit 20 is flipped, the counter circuit 30 stops working, the quantization of the first pixel pulse signal is ended. At this time, a third digital code value is generated based on the counting of the counter circuit 30, where the third digital code value is the difference between the digital code values corresponding to the first pixel signal and the reset signal, thus, the correlated double sampling is realized, the noise influence is reduced and the imaging quality is improved.

Afterwards, the counter circuit 30 is reset. Before the second exposure sampling time period, the storage circuit 50, upon receiving the write-back control signal rewrite_en, is configured to write back the stored first digital code value to the counter circuit 30. In the meantime, the counter circuit 30, upon receiving the inversion control signal trig_pulse, is configured to invert the written-back first digital code value to generate a fourth digital code value, in this case, the fourth digital code value is equal to the second digital code value. The fourth digital code value is served as an initial state of the second exposure sampling. Then, the counter circuit 30 is restored to the counting mode and configured to perform a quantization on the second pixel signal in the second exposure sampling time period. The comparison circuit 20 is configured to compare the second pixel signal with the pixel ramp voltage signal and generate a second pixel pulse signal. The second pixel pulse signal is output to the counter circuit 30. The counter circuit 30 is configured to count the second pixel pulse signal in the same direction based on the fourth digital code value. When the output of the comparison circuit 20 is flipped, the counter circuit 30 stops counting, and the quantization of the second pixel pulse signal is ended. At this time, a fifth digital code value is generated based on the counting of the counter circuit 30, where the fifth digital code value is the difference between the digital code values corresponding to the second pixel signal and the reset signal, thus, the correlated double sampling is realized, the noise influence is reduced and the imaging quality is improved.

In the meantime, the third digital code value and the fifth digital code value obtained by the two quantizations are finally stored in the storage circuit 50, and read out to the corresponding control circuit 3 under the control of the readout control signal, and the image information is determined by the control circuit 3 according to the third digital code value and the fifth digital code value.

In case that the reset signal includes two reset signals corresponding to two pixel signals, then in the first reset sampling time period, the comparison circuit 20 is configured to compare the first reset signal with the reset ramp voltage signal and generate a first reset pulse signal. The first reset pulse signal is input to the counter circuit 30. The counter circuit 30 is configured to count up or down the first reset pulse signal, and when the output of the comparison circuit 20 is flipped, the counter circuit 30 stops counting, the quantization of the first reset signal is ended, where a 1-st first digital code value is generated based on the counting of the counter circuit 30 and written by the counter circuit 30 into the storage circuit 50.

Before the second reset sampling time period, the counter circuit 30 is reset, and during the second reset sampling time period, the comparison circuit 20 is configured to compare the second reset signal with the reset ramp voltage signal and generate a second reset pulse signal. The second reset pulse signal is output to the counter circuit 30. The counter circuit 30 is configured to count the second reset pulse signal in the same direction, and when the output of the comparison circuit 20 is flipped, the counter circuit 30 stops counting, the quantization of the second reset signal is ended, where a 2-nd first digital code value is generated based on the counting of the counter circuit 30 and stored by the counter circuit 30 in the counter circuit 30.

Before the first exposure sampling time period, the inversion control circuit 40, upon receiving the mode selection signal mode_sel, is configured to output the inversion control signal trig_pulse to the counter circuit 30, the counter circuit 30 is then switched to the inversion mode and configured to invert the stored 2-nd first digital code value to the second digital code value as an initial state of the first exposure sampling time period. Then, the counter circuit 30 is restored to the counting mode, and in the first exposure sampling time period, the comparison circuit 20 is configured to compare the first pixel signal with the pixel ramp voltage signal and generate a first pixel pulse signal. The first pixel pulse signal is output to the counter circuit 30. The counter circuit 30 is configured to count the first pixel pulse signal in the same direction based on the second digital code value, and when the output of the comparison circuit 20 is flipped, the counter circuit 30 stops working, the quantization of the first pixel pulse signal is ended. At this time, a third digital code value is generated based on the counting of the counter circuit 30, where the third digital code value is the difference between the digital code values corresponding to the first pixel signal and the second reset signal, thus the correlated double sampling is realized, the noise influence is reduced and the imaging quality is improved.

Afterwards, the counter circuit 30 is reset. Before the second exposure sampling time period, the storage circuit 50, upon receiving the write-back control signal rewrite_en, is configured to write back the stored 1-st first digital code value to the counter circuit 30. In the meantime, the counter circuit 30, upon receiving the inversion control signal trig_pulse, is configured to invert the written-back 1-st first digital code value to generate a fourth digital code value. The fourth digital code value is served as an initial state of the second exposure sampling. Then, the counter circuit 30 is restored to the counting mode and configured to perform a quantization on the second pixel signal in the second exposure sampling time period. The comparison circuit 20 is configured to compare the second pixel signal with the pixel ramp voltage signal and generate a second pixel pulse signal. The second pixel pulse signal is output to the counter circuit 30. The counter circuit 30 is configured to count the second pixel pulse signal in the same direction based on the fourth digital code value. When the output of the comparison circuit 20 is flipped, the counter circuit 30 stops counting, and the quantization of the second pixel pulse signal is ended. At this time, a fifth digital code value is generated based on the counting of the counter circuit 30, where the fifth digital code value is the difference between the digital code values corresponding to the second pixel signal and the second reset signal, thus the correlated double sampling is realized, the noise influence is reduced and the imaging quality is improved.

In the meantime, the third digital code value and the fifth digital code value obtained by the two quantizations are finally stored in the storage circuit 50, and read out to the corresponding control circuit 3 according to the readout control signal, and the image information is determined by the control circuit 3 according to the third digital code value and the fifth digital code value.

In an entire quantization process, only one reset signal needs to be quantized, and the pixel signals read out twice are time-division multiplexed with a set of counter circuits 30. Hereby, only one set of readout circuits 1 is needed to complete the quantization of two pixel pulse signals, which simplifies the structure of the image sensor and reduces the power consumption. In addition, the image information is determined according to the quantization results of the two pixel pulse signals, to realize the automatic focus or high dynamic range, thus, the imaging quality is improved.

The counter circuit 30, the inversion control circuit 40 and the storage circuit 50 may be particularly determined according to the corresponding reset signal, the type of pixel signal and the input and output logic.

And, the write-back path of the storage circuit 50 may be a direct output to the counter circuit 30, or an indirect output to the counter circuit 30 via the inversion control circuit 40, and the specific write-back mode is not limited.

Compared with the existing technologies, the embodiments of the present application have the following beneficial effects that: in the above-mentioned image sensor circuit, the reset signal is quantized as the first digital code value and stored during the reset sampling time period, the first pixel pulse signal is quantized based on the second digital code value during the first exposure sampling time period to achieve a correlated double sampling, and the second pixel pulse signal is quantized based on the fourth digital code value during the second exposure sampling time period to achieve a correlated double sampling, where the second digital code value and the fourth digital code value are both the inverted value of the corresponding first digital code value, thus, in the entire quantization process, the reset signal only needs to be quantized once, and the pixel signals read out twice are time-division multiplexed with a set of counter circuits 30, so only one set of readout circuits 1 is needed to complete the quantization of the two pixel pulse signals, which simplifies the structure of the image sensor and reduces the power consumption, in addition, the image information is determined according to the quantization results of the two pixel pulse signals, to achieve the automatic focus or high dynamic range, thus the imaging quality is improved.

### Embodiment 7

Optimization and concretization on the basis of Embodiment 6. In an optional embodiment, the image sensor includes a pixel array 100, each pixel array 100 includes pixel units arranged in an array, and each readout circuit 1 of the image sensor is connected to a plurality of pixel units arranged in a column, and the pixel unit includes at least four sub-pixels arranged in a 2×2 manner, where at least two sub-pixels constitute a pixel group and are controlled to output simultaneously a reset signal or a pixel signal.

At least one reset signal is a reset signal generated when the pixel units are reset simultaneously.

The first pixel pulse signal and the second pixel pulse signal are respectively one of a pixel-group pulse signal corresponding to a simultaneous exposure of pixel groups and an image pulse signal corresponding to a simultaneous exposure of sub-pixels in the pixel units.

In this embodiment, the readout circuit 1 is suitable for ADAF technology, and the four sub-pixels share a floating diffusion node and a source follower transistor. When reading out, a pixel group is first switched on, and the pixel group signal Vsigl of at least two sub-pixels in the pixel group is read out, for example, the two pixel signals on the right are read out to obtain right phase information.

Then, all the sub-pixels of the pixel unit are switched on, and the image signal Vsig corresponding to the pixel unit is read out. Correspondingly, the comparison circuit 20 obtains full phase information.

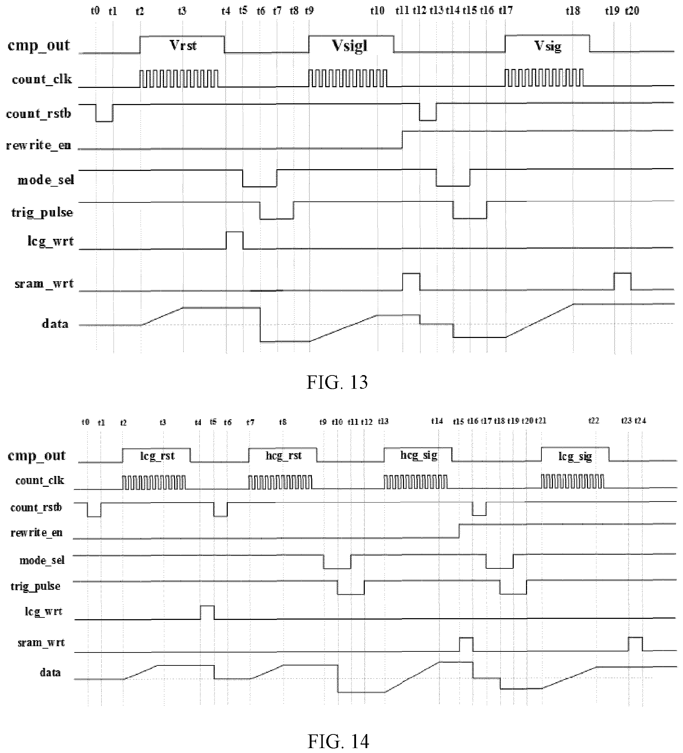

Particularly, as shown in FIG. 13, during the reset sampling time period, the comparison circuit 20 is configured to compare the reset signal with the reset ramp voltage signal and generate a reset pulse signal. The reset pulse signal is input to the counter circuit 30. The counter circuit 30 is configured to count up or down the reset pulse signal, and when the output of the comparison circuit 20 is flipped, the counter circuit 30 stops counting, the quantization of reset signal is ended, where a first digital code value generated based on the counting of the counter circuit 30 is stored in the counter circuit 30 and written by the counter circuit 30 into the storage circuit 50.

Before the first exposure sampling time period, the inversion control circuit 40, upon receiving the mode selection signal mode_sel, is configured to output the inversion control signal trig_pulse to the counter circuit 30, the counter circuit 30 is then switched to the inversion mode and configured to invert the stored first digital code value to a second digital code value as an initial state of the first exposure sampling time period. Then, the counter circuit 30 is restored to the counting mode, and in the first exposure sampling time period, the comparison circuit 20 is configured to compare the pixel group signal Vsigl with the pixel ramp voltage signal and generate a pixel-group pulse signal. The pixel-group pulse signal is output to the counter circuit 30. The counter circuit 30 is configured to count the pixel-group pulse signal in the same direction based on the second digital code value, and when the output of the comparison circuit 20 is flipped, the counter circuit 30 stops working, the quantization of the pixel-group pulse signal is ended. At this time, a third digital code value is generated based on the counting of the counter circuit 30, where the third digital code value is a difference between the digital code values corresponding to the pixel group signal Vsigl and the reset signal, that is, Vsigr-Vrst, thus, the correlated double sampling is realized, the noise influence is reduced and the imaging quality is improved.

Afterwards, the counter circuit 30 is reset. Before the second exposure sampling time period, the storage circuit 50, upon receiving the write-back control signal rewrite_en, is configured to write back the stored first digital code value to the counter circuit 30. In the meantime, the counter circuit 30, upon receiving the inversion control signal trig_pulse, is configured to invert the written-back first digital code value to generate a fourth digital code value, in this case, the fourth digital code value is equal to the second digital code value. The fourth digital code value is served as an initial state of the second exposure sampling. Then, the counter circuit 30 is restored to the counting mode and configured to perform a quantization on the image signal Vsig in the second exposure sampling time period. The comparison circuit 20 is configured to compare the image signal Vsig with the pixel ramp voltage signal and generate an image pulse signal. The image pulse signal is output to the counter circuit 30. The counter circuit 30 is configured to count the image pulse signal in the same direction based on the fourth digital code value. When the output of the comparison circuit 20 is flipped, the counter circuit 30 stops counting, and the quantization of image pulse signal is ended. At this time, a fifth digital code value generated based on the counting of the counter circuit 30, where the fifth digital code value is a difference between the digital code values corresponding to the second pixel signal and the reset signal, that is, Vsigr+Vsigl-Vrst, thus, the correlated double sampling is realized, the noise influence is reduced and the imaging quality is improved.

In the meantime, the third digital code value and the fifth digital code value obtained by the two quantizations are finally stored in the storage circuit 50, and read out to the corresponding control circuit 3 according to the readout control signal. The control circuit 3 can determine information on the left and right pixels or information on the upper and lower pixels based on the fifth digital code value and the third digital code value, and can obtain a phase difference through the pixel information to perform automatic focusing, which improves the user experience.

Moreover, during the quantization process, only one reset signal needs to be quantized, and the pixel signals read out twice are time-division multiplexed with a set of counter circuits 30, which simplifies the structure of the image sensor and reduces power consumption. The image information is determined based on the quantization results of the two pixel pulse signals, thereby the automatic focusing is achieved and the imaging quality is improved.

### Embodiment 8

Optimization and concretization on the basis of Embodiment 6. In another optional embodiment, the reset sampling time period includes a first reset sampling time period and a second reset sampling time period following immediately the first reset sampling time period, and the at least one reset pulse signal includes a high-gain reset pulse signal and a low-gain reset pulse signal.

The first pixel pulse signal and the second pixel pulse signal are respectively one of a high-gain image pulse signal and a low-gain image pulse signal.

The counter circuit 30 is configured to: count one of the reset pulse signals to generate a first digital code value in the first reset sampling time period;
count the other one of the reset pulse signals to generate another first digital code value in the second reset sampling time period;
count the first pixel pulse signal based on a second digital code value and store a counting result as a third digital code value in the first exposure sampling time period; and
count the second pixel pulse signal based on a fourth digital code value and store a counting result as a fifth digital code value in the second exposure sampling time period.

In this embodiment, the readout circuit 1 is suitable for HDR technology, and the pixel unit or sub-pixel includes different integral capacitors, and different integral capacitors are switched under different illuminations. Herein, under low illumination conditions, a smaller integral capacitor is applied to increase a conversion gain to improve the sensitivity; under high illumination conditions, a larger integral capacitor is applied to increase a charge storage, where the conversion gain is decreased to improve the dynamic range.

Correspondingly, the reset signal includes a low-gain reset signal lcg_rst and a high-gain reset signal hcg_rst. Referring to FIG. 14, in the first reset sampling time period, the comparison circuit 20 is configured to compare the first reset signal with the reset ramp voltage signal and generate a first reset pulse signal. The first reset pulse signal is input to the counter circuit 30. The counter circuit 30 is configured to count up or down the first reset pulse signal, and when the output of the comparison circuit 20 is flipped, the counter circuit 30 stops counting, the quantization of the first reset signal is ended, where a 1-st first digital code value is generated based on the counting of the counter circuit 30 and written by the counter circuit 30 into the storage circuit 50.

Before the second reset sampling time period, the counter circuit 30 is reset, and during the second reset sampling time period, the comparison circuit 20 is configured to compare the second reset signal with the reset ramp voltage signal and generate a second reset pulse signal. The second reset pulse signal is output to the counter circuit 30. The counter circuit 30 is configured to count the second reset pulse signal in the same direction, and when the output of the comparison circuit 20 is flipped, the counter circuit 30 stops counting, and the quantization of the second reset signal is ended, where a 2-nd first digital code value is generated based on the counting of the counter circuit 30 and stored by the counter circuit 30 in the counter circuit 30.

Herein, one of the second reset signal and the first reset signal is the high-gain reset signal hcg_rst and the other one is the low-gain reset signal lcg_rst. Correspondingly, one of the second reset pulse signal and the first reset pulse signal is the high-gain reset pulse signal and the other one is the low-gain reset pulse signal.

Before the first exposure sampling time period, the inversion control circuit 40, upon receiving the mode selection signal mode_sel, is configured to output the inversion control signal trig_pulse to the counter circuit 30, the counter circuit 30 is then switched to the inversion mode and configured to invert the stored 2-nd first digital code value to a second digital code value as an initial state of the first exposure sampling time period. Then, the counter circuit 30 is restored to the counting mode, and in the first exposure sampling time period, the comparison circuit 20 is configured to compare the first pixel signal with the pixel ramp voltage signal, where the first pixel signal and the second reset signal are respectively the image signal and the reset signal under the same gain, for example the first pixel signal and the second reset signal are respectively the high-gain image signal hcg_sig and the high-gain reset signal hcg_rst. The first pixel signal and the pixel ramp voltage signal are compared to generate the first pixel pulse signal. The first pixel pulse signal is output to the counter circuit 30. The counter circuit 30 is configured to count the first pixel pulse signal in the same direction based on the second digital code value, and when the output of the comparison circuit 20 is flipped, the counter circuit 30 stops working, the quantization of the first pixel pulse signal is ended. At this time, a third digital code value is generated based on the counting of the counter circuit 30, where the third digital code value is a difference between the digital code values corresponding to the first pixel signal and the second reset signal, thus, the correlated double sampling is realized, the noise influence is reduced and the imaging quality is improved.

Afterwards, the counter circuit 30 is reset. Before the second exposure sampling time period, the storage circuit 50, upon receiving the write-back control signal rewrite_en, is configured to write back the stored 1-st first digital code value to the counter circuit 30. In the meantime, the counter circuit 30, upon receiving the inversion control signal trig_pulse, is configured to invert the written-back 1-st first digital code value to generate a fourth digital code value. The fourth digital code value is served as an initial state of the second exposure sampling. Then, the counter circuit 30 is restored to the counting mode and configured to perform a quantization on the second pixel signal in the second exposure sampling time period. The second pixel signal and the first reset signal are respectively the image signal and reset signal under the same gain, for example, the second pixel signal and the first reset signal are respectively the low-gain image signal lcg_sig and low-gain reset signal lcg rst. The comparison circuit 20 is configured to compare the second pixel signal with the pixel ramp voltage signal and generate a second pixel pulse signal. The second pixel pulse signal is output to the counter circuit 30. The counter circuit 30 is configured to count the second pixel pulse signal in the same direction based on the fourth digital code value, and when the output of the comparison circuit 20 is flipped, the counter circuit 30 stops counting, the quantization of the second pixel pulse signal is ended. At this time, a fifth digital code value is generated based on the counting of the counter circuit 30, where the fifth digital code value is a difference between the digital code values corresponding to the second pixel signal and the first reset signal, thus, the correlated double sampling is realized, the noise influence is reduced and the imaging quality is improved.

In the meantime, the third digital code value and the fifth digital code value obtained by the two quantizations are finally stored in the storage circuit 50, and read out to the corresponding control circuit 3 according to the readout control signal, and the image information is determined by the control circuit 3 according to the third digital code value and the fifth digital code value.

In the entire quantization process, only one reset signal needs to be quantized, and the pixel signals read out twice are time-division multiplexed with a set of counter circuits 30. Thus, only one set of readout circuits 1 is needed to complete the quantization of two pixel pulse signals, which simplifies the structure of the image sensor and reduces the power consumption. The image information is determined based on the quantization results of the two pixel pulse signals, thereby a high dynamic range is achieved and the imaging quality is improved.

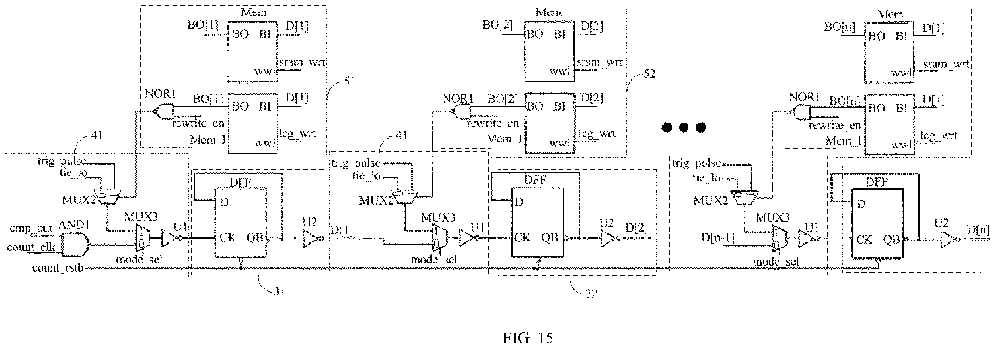

Corresponding to the signal input and output logic of the above-mentioned embodiments 7 and 8, optionally, as shown in FIG. 15, the counter circuit 30 includes a first counter unit 31 to an n-th counter unit.

The storage circuit 50 includes n storage units, such as a first storage unit 51, a second storage unit 52, ... etc., and one storage unit is connected with one counter unit and an inversion control circuit 40.

Each storage unit includes a first memory Mem1, a second memory Mem2 and a NAND gate NOR1.

Input ends of the first memory Mem1 and the second memory Mem2 are respectively connected to a counter unit, and an output end of the first memory Mem1 is connected to a first input end of the NAND gate NOR1, and a second input end of the NAND gate NOR1 is configured for an input of the write-back control signal rewrite_en, and the NAND gate NOR1 constitutes an output end of the storage unit;
The first memory Mem1 is configured to store a corresponding one-bit count value of at least one first digital code value.

The first memory Mem1 and the second memory Mem2 are configured to respectively store a corresponding one-bit count value of the third digital code value or the fifth digital code value.

When applied to the readout circuit 1 of Embodiment 7, referring to FIG. 12, FIG. 13 and FIG. 15, in the reset sampling time period, the comparison circuit 20 is configured to compare the reset signal with the reset ramp voltage signal and generate a reset pulse signal. The reset pulse signal is input to the counter circuit 30. The reset pulse signal is output via the inversion control circuit 40 to the first counter unit 31 to the n-th counter unit. The n counter units are configured to count up or down the reset pulse signal, and when the output of the comparison circuit 20 is flipped, the n counter units stop counting, the quantization of the reset signal is ended, where all bits of count values of the first digital code value are generated based on the counting of the n counter units and respectively stored by the n counter units in the corresponding first memory Mem1.

Before the first exposure sampling time period, the inversion control circuit 40, upon receiving the mode selection signal mode_sel, is configured to output the inversion control signal trig_pulse to the counter circuit 30, the n counter units then are switched to the inversion mode, and the stored first digital code value is inverted to a second digital code value as an initial state of the first exposure sampling time period. Then, the n counter units are restored to the counting mode, and in the first exposure sampling time period, the comparison circuit 20 is configured to compare the pixel group signal Vsigl with the pixel ramp voltage signal and generate a pixel-group pulse signal. The pixel-group pulse signal is output via the inversion control circuit 40 to n counter units. The n counter units are respectively configured to count the pixel-group pulse signal in the same direction based on the second digital code value, and when the output of the comparison circuit 20 is flipped, the n counter units stop counting, and the quantization of the pixel-group pulse signal is ended. At this time, a third digital code value is generated based on the counting of the n counter units, wherein the third digital code value is a difference between the digital code values corresponding to the pixel group signal Vsigl and the reset signal, that is, Vsigr-Vrst, thus, the correlated double sampling is realized, the noise influence is reduced and the imaging quality is improved. The n bits of count values in the third digital code value are respectively stored in n second memories Mem2.

Afterwards, the n counter units are reset. Before the second exposure sampling time period, each first memoryMem1, upon receiving the write-back control signal rewrite_en, is configured to write back the respective stored count value of first digital code value to the counter circuit 30 via the respective NAND gate NOR1 and the inversion control circuit 40. In the meantime, the n counter units, upon receiving the inversion control signal trig_pulse, is configured to invert the written-back first digital code value to generate a fourth digital code value, in this case, the fourth digital code value is equal to the second digital code value, and the fourth digital code value is served as an initial state of the second exposure sampling. Then, the n counter units are restored to the counting mode and configured to quantize the image signal Vsig in the second exposure sampling time period. The comparison circuit 20 is configured to compare the image signal Vsig with the pixel ramp voltage signal and generate an image pulse signal. The image pulse signal is output to the n counter units. The n counter units are configured to count the image pulse signal in the same direction based on the fourth digital code value, and when the output of the comparison circuit 20 is flipped, the counter circuit 30 stops counting, the quantization of the image pulse signal is ended. At this time, a fifth digital code value is generated based on the counting of the counter circuit 30. The n bits of count values of the fifth digital code value are respectively stored in the first memories Mem1, where the fifth digital code value is a difference between the digital code values corresponding to the second pixel signal and the reset signal, that is, Vsigr+Vsigl-Vrst, thus, the correlated double sampling is realized, the noise influence is reduced and the imaging quality is improved.

When applied to the readout circuit 1 of Embodiment 7, referring to FIG. 11, FIG. 13 and FIG. 14, in the first reset sampling time period, the comparison circuit 20 is configured to compare the first reset signal with the reset ramp voltage signal and generate a first reset pulse signal. The first reset pulse signal corresponds to a high-gain reset pulse signal hcg_rst or a low-gain reset pulse signal lcg rst. The first reset pulse signal is input to n counter units via the inversion control circuit 40. The n counter units are configured to count up or down the first reset pulse signal, and when the output of the comparison circuit 20 is flipped, the n counter units stop counting, the quantization of the first reset signal is ended, where n count values are generated based on the counting of the n counter units, and the n count values are combined to generate a 1-st first digital code value and are respectively written into the n first memories Mem1.

Before the second reset sampling time period, the n counter units are reset, and during the second reset sampling time period, the comparison circuit 20 is configured to compare the second reset signal with the reset ramp voltage signal and generate a second reset pulse signal. One of the second reset signal and the first reset signal is a high-gain reset signal hcg_rst, and the other is a low-gain reset signal lcg rst. One of the second reset pulse signal and the first reset pulse signal is a high-gain reset pulse signal, and the other is a low-gain reset pulse signal. The second reset pulse signal is output to the n counter units via the inversion control circuit 40. The n counter units are configured to respectively count the second reset pulse signal in the same direction, and when the output of the comparison circuit 20 is flipped, the n counter units stop counting, and the quantization of the second reset signal is ended, where n count values are generated based on the counting of the n counter units, and the n count values are combined to generate the 2-nd first digital code value and are respectively stored by and in the n counter units.

Before the first exposure sampling time period, the inversion control circuit 40, upon receiving the mode selection signal mode_sel, is configured to output the inversion control signal trig_pulse to the n counter units, and the n counter units are then switched to the inversion mode and configured to invert the count values stored therein respectively, and the count values after inversion are combined to generate a second digital code value as an initial state of the first exposure sampling time period. Then, the n counter units are restored to the counting mode, and in the first exposure sampling time period, the comparison circuit 20 is configured to compare the first pixel signal with the pixel ramp voltage signal and generate a first pixel pulse signal based on the comparison. The first pixel pulse signal is output to the n counter units via the inversion control circuit 40. The n counter units are configured to count the first pixel pulse signal in the same direction based on the second digital code value, and when the output of the comparison circuit 20 is flipped, the n counter units stop working, the quantization of the first pixel pulse signal is ended. At this time, a third digital code value is generated based on the counting of the n counter units, and all bits of count values of the third digital code value are respectively stored in the second memories Mem2, where the third digital code value is a difference between the digital code values corresponding to the first pixel signal and the second reset signal, thus the correlated double sampling is realized, the noise influence is reduced and the imaging quality is improved.

Afterwards, the n counter units are reset, and before the second exposure sampling time period, all first memories Mem1, upon receiving the write-back control signal rewrite_en, are configured to respectively write back their stored count values of the 1-st first digital code value to the n counter units. In the meantime, the n counter units, upon receiving the inversion control signal trig_pulse, are configured to invert the written-back 1-st first digital code value to generate a fourth digital code value. The fourth digital code value is served as an initial state of the second exposure sampling. Then, the n counter units are restored to the counting mode and configured to quantize the second pixel signal in the second exposure sampling time period. The comparison circuit 20 is configured to compare the second pixel signal with the pixel ramp voltage signal and generate a second pixel pulse signal. The second pixel pulse signal is output to n counter units. The n counter units are configured to count the second pixel pulse signal in the same direction based on the fourth digital code value, and when the output of the comparison circuit 20 is flipped, the n counter units stop counting, and the quantization of the second pixel pulse signal is ended. At this time, a fifth digital code value is generated based on the counting of the n counter units, where the fifth digital code value is a difference between the digital code values corresponding to the second pixel signal and the first reset signal. The n bits of count values of the fifth digital code value are respectively stored in the n first memories Mem1, thus, the correlated double sampling is realized, the noise influence is reduced, and the imaging quality is improved.

### Embodiment 9

Optimization and concretization on the basis of Embodiment 6. In another optional embodiment, the image sensor includes a pixel array 100, each pixel array 100 includes pixel units arranged in an array, and each readout circuit 1 of the image sensor is connected to a plurality of pixel units arranged in a column, and the pixel unit includes at least four sub-pixels arranged in a 2×2 manner, where at least two sub-pixels constitute a pixel group and are controlled to output simultaneously a reset signal or a pixel signal.

The reset sampling time period includes a first reset sampling time period and a second reset sampling time period following immediately the first reset sampling time period, and the at least one reset pulse signal includes a high-gain reset pulse signal and a low-gain reset pulse signal.

The first pixel pulse signal includes a high-gain image pulse signal, and the second pixel pulse signal includes a low-gain pixel-group pulse signal corresponding to a simultaneous exposure of pixel groups in a low-gain mode and a low-gain image pulse signal corresponding to a simultaneous exposure of sub-pixels in the pixel units under the low-gain mode.

The second exposure sampling time period includes a third exposure sampling time period and a fourth exposure sampling time period following immediately the third exposure sampling time period.

The first digital code value includes a first sub-digital code value and a second sub-digital code value.

The counter circuit 30 is configured to: count the low-gain reset pulse signal to generate the first sub-digital code value in the first reset sampling time period; count the high-gain reset pulse signal to generate the second sub-digital code value in the second reset sampling time period; and count the high-gain image pulse signal based on the second digital code value and store a counting result as the third digital code value in the first exposure sampling time period.

The fifth digital code value includes a fifth sub-digital code value and a sixth sub-digital code value.

The counter circuit 30 is also configured to: count the low-gain pixel-group pulse signal based on the fourth digital code value and store a counting result as the fifth sub-digital code value in the third exposure sampling time period; and count the low-gain image pulse signal based on the fourth digital code value and store a counting result as the sixth sub-digital code value in the fourth exposure sampling time period.

The storage circuit 50 is connected to the counter circuit 30 and configured to store the first sub-digital code value. Before the third exposure sampling time period and the fourth exposure sampling time period, the storage circuit 50 is configured, in response to a triggering of the write-back control signal rewrite_en, to write back the first sub-digital code value to the counter circuit 30.

The inversion control circuit 40 is connected to the counter circuit 30 and the storage circuit 50. Before each exposure sampling time period, the inversion control circuit 40 is configured, in response to a triggering of the inversion control signal trig_pulse, to control the counter circuit 30 to invert the stored first sub-digital code value to generate the fourth digital code value, and to invert the second sub-digital code value to generate the second digital code value.

In this embodiment, the readout circuit 1 is suitable for realizing automatic focusing under low conversion gain. The reset pulse signal includes the high-gain reset pulse signal and the low-gain reset pulse signal. The first pixel pulse signal includes the high-gain image pulse signal. The second pixel pulse signal includes the low-gain pixel-group pulse signal corresponding to the simultaneous exposure of the pixel groups in the low-gain mode and the low-gain image pulse signal corresponding to the simultaneous exposure of the sub-pixels in the pixel units under the low-gain mode.

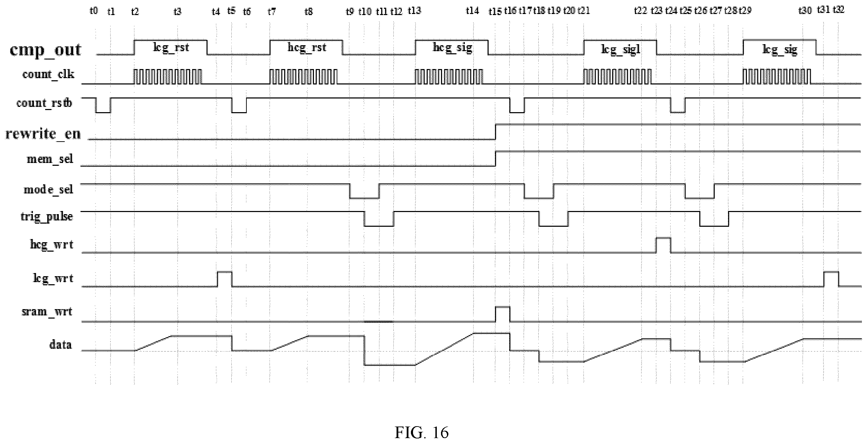

Referring to FIG. 16, in the first reset sampling time period, the comparison circuit 20 is configured to compare the low-gain reset signal lcg_rst with the reset ramp voltage signal and generate a low-gain reset pulse signal. The low-gain reset pulse signal is input to the counter circuit 30. The counter circuit 30 is configured to count up or down the low-gain reset pulse signal, and when the output of the comparison circuit 20 is flipped, the counter circuit 30 stops counting, the quantization of the low-gain reset signal lcg_rst is ended, where the first sub-digital code value is generated based on the counting of the counter circuit 30 and written by the counter circuit 30 into the storage circuit 50.

Before the second reset sampling time period, the counter circuit 30 is reset, and in the second reset sampling time period, the comparison circuit 20 is configured to compare the high-gain reset signal hcg_rst with the reset ramp voltage signal and generate a high-gain reset pulse signal. The high-gain reset pulse signal is output to the counter circuit 30. The counter circuit 30 is configured to count the high-gain reset pulse signal in the same direction, and when the output of the comparison circuit 20 is flipped, the counter circuit 30 stops counting, the quantization of the high-gain reset signal hcg_rst is ended, where the second sub-digital code value is generated based on the counting of the counter circuit 30 and stored by the counter circuit 30 in the counter circuit 30 .

Before the first exposure sampling time period, the inversion control circuit 40, upon receiving the mode selection signal mode_sel, is configured to output the inversion control signal trig_pulse to the counter circuit 30, the counter circuit 30 is then switched to the inversion mode and configured to invert the stored second sub-digital code value to a second digital code value as an initial state of the first exposure sampling time period. Then, the counter circuit 30 is restored to the counting mode, and in the first exposure sampling time period, the comparison circuit 20 is configured to compare the high-gain image signal hcg_sig with the pixel ramp voltage signal and generate a high-gain image pulse signal based on the comparison. The high-gain image pulse signal is output to the counter circuit 30. The counter circuit 30 is configured to count the high-gain image pulse signal in the same direction based on the second digital code value, and when the output of the comparison circuit 20 is flipped, the counter circuit 30 stops working, the quantization of the high-gain image pulse signal is ended. The third digital code value is generated based on the counting of the counter circuit 30, where the third digital code value is a difference between the digital code values corresponding to the high-gain image signal hcg_sig and the high-gain reset signal hcg_rst, thus, the correlated double sampling is realized, the noise influence is reduced and the imaging quality is improved.

Afterwards, the counter circuit 30 is reset. Before the third exposure sampling time period, the storage circuit 50, upon receiving the write-back control signal rewrite_en, is configured to write back the stored first sub-digital code value to the counter circuit 30. In the meantime, the counter circuit 30, upon receiving the inversion control signal trig_pulse, is configured to invert the written-back first sub-digital code value to generate a fourth digital code value. The fourth digital code value is served as an initial state of the third exposure sampling time period. Then, the counter circuit 30 is restored to the counting mode and configured to quantize the low-gain pixel group signal lcg_sigl in the third exposure sampling time period. The comparison circuit 20 is configured to compare the low-gain pixel group signal lcg_sigl with the pixel ramp voltage signal and generate a low-gain pixel-group pulse signal. The low-gain pixel-group pulse signal is output to the counter circuit 30. The counter circuit 30 is configured to count the low-gain pixel-group pulse signal in the same direction based on the fourth digital code value, and when the output of the comparison circuit 20 is flipped, the counter circuit 30 stops counting, and the quantization of the low-gain pixel-group pulse signal is ended. At this time, a fifth sub-digital code value is generated based on the counting of the counter circuit 30, where the fifth sub-digital code value is a difference between the digital code values corresponding to the low-gain pixel group signal lcg_sigl and the low-gain reset signal lcg_rst, thus, the correlated double sampling is realized, the noise influence is reduced and the imaging quality is improved.

Then, the counter circuit 30 is reset again. Before the fourth exposure sampling time period, the storage circuit 50, upon receiving the write-back control signal rewrite_en, is configured to write back the stored first sub-digital code value to the counter circuit 30 again. In the meantime, the counter circuit 30, upon receiving the inversion control signal trig_pulse, is configured to invert the written-back first sub-digital code value to generate a fourth digital code value. The fourth digital code value is served as an initial state of the fourth exposure sampling time period. Then, the counter circuit 30 is restored to the counting mode and configured to quantize the low-gain image signal lcg_sig in the fourth exposure sampling time period. The comparison circuit 20 is configure to compare the low-gain image signal lcg_sig with the pixel ramp voltage signal and generate a low-gain image pulse signal. The low-gain image pulse signal is output to the counter circuit 30. The counter circuit 30 is configured to count the low-gain image pulse signal in the same direction based on the fourth digital code value, and when the output of the comparison circuit 20 is flipped, the counter circuit 30 stops counting, and the quantization of the low-gain image pulse signal is ended. At this time, a sixth sub-digital code value is generated based on the counting of the counter circuit 30, where the sixth sub-digital code value is a difference between the digital code values corresponding to the low-gain image signal lcg_sig and the low-gain reset signal lcg_rst, thus, the correlated double sampling is realized, the noise influence is reduced and the imaging quality is improved.

In the meantime, the third digital code value, the fifth sub-digital code value, and the sixth sub-digital code value obtained by the three quantizations are finally stored in the storage circuit 50 and read out to the corresponding control circuit 3 according to the readout control signal. The image information is determined by the control circuit 3 according to the third digital code value, the fifth sub-digital code value, and the sixth sub-digital code value, and the automatic focusing in the low conversion gain mode is achieved, which improves the imaging quality and user experiences.

### Embodiment 10

Optimization and concretization on the basis of Embodiment 6. In another optional embodiment, the image sensor includes a pixel array 100, each pixel array 100 includes pixel units arranged in an array, and each readout circuit 1 of the image sensor is connected to a plurality of pixel units arranged in a column, and the pixel unit includes four sub-pixels arranged in a 2×2 manner, where two sub-pixels constitute a pixel group and are controlled to output a reset signal or a pixel signal simultaneously.

The reset sampling time period includes a first reset sampling time period and a second reset sampling time period following immediately the first reset sampling time period, and the at least one reset pulse signal includes a high-gain reset pulse signal and a low-gain reset pulse signal.

The first pixel pulse signal includes a high-gain pixel-group pulse signal corresponding to a simultaneous exposure of pixel groups in a high-gain mode and a high-gain image pulse signal corresponding to a simultaneous exposure of sub-pixels in the pixel units under the high-gain mode.

The second pixel pulse signal includes a low-gain image pulse signal.

The first exposure sampling time period includes a third exposure sampling time period and a fourth exposure sampling time period following immediately the third exposure sampling time period

The first digital code value includes a first sub-digital code value and a second sub-digital code value.

The counter circuit 30 is configured to: count the low-gain reset pulse signal to generate the first sub-digital code value in the first reset sampling time period; and count the high-gain reset pulse signal to generate the second sub-digital code value in the second reset sampling time period.

The third digital code value includes a third sub-digital code value and a fourth sub-digital code value;

The counter circuit 30 is also configured to: count the high-gain pixel-group pulse signal based on the second digital code value and store a counting result as the third sub-digital code value in the third exposure sampling time period; count the high-gain image pulse signal based on the second digital code value and store a counting result as the fourth sub-digital code value in the fourth exposure sampling time period; and count the low-gain image pulse signal based on the fourth digital code value and store a counting result as the fifth digital code value in the second exposure sampling time period.

The storage circuit 50 is connected to the counter circuit 30 and configured to store the first sub-digital code value and the second sub-digital code value. Before the fourth exposure sampling time period and the second exposure sampling time period, the storage circuit 50 is configured, in response to a triggering of the write-back control signal rewrite_en, to write back the second sub-digital code value and the first sub-digital code value to the counter circuit 30.

The inversion control circuit 40 is connected to the counter circuit 30 and the storage circuit 50. Before each exposure sampling time period, the inversion control circuit 40 is configured, in response to a triggering of the inversion control signal trig_pulse, to control the counter circuit 30 to invert the stored second sub-digital code value to generate the second digital code value, and to invert the first sub-digital code value to generate the fourth digital code value.

In this embodiment, the readout circuit 1 is suitable for realizing automatic focusing under high conversion gain, The reset pulse signal includes the high-gain reset pulse signal and the low-gain reset signal lcg_rst. The first pixel pulse signal includes the high-gain pixel-group pulse signal corresponding to the simultaneous exposure of the pixel groups in the high-gain mode and the high-gain image pulse signal corresponding to the simultaneous exposure of the sub-pixels in the pixel units under the high-gain mode. The second pixel pulse signal includes a low-gain image pulse signal.

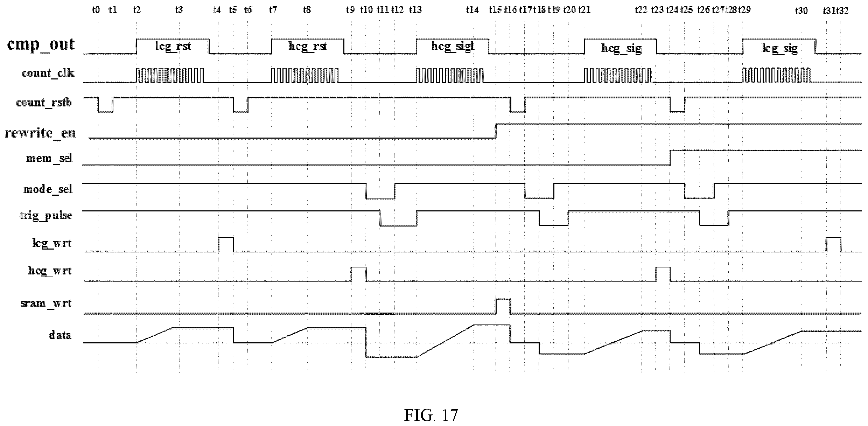

Referring to FIG. 17, in the first reset sampling time period, the comparison circuit 20 is configured to compare the low-gain reset signal lcg_rst with the reset ramp voltage signal, generate a low-gain reset pulse signal and input the same to the counter circuit 30. The counter circuit 30 is configured to count up or down the low-gain reset pulse signal, and when the output of the comparison circuit 20 is flipped, the counter circuit 30 stops counting, the quantization of the low-gain reset signal lcg rst is ended, where the first sub-digital code value is generated based on the counting of the counter circuit 30 and written by the counter circuit 30 into the storage circuit 50.

Before the second reset sampling time period, the counter circuit 30 is reset, and in the second reset sampling time period, the comparison circuit 20 is configured to compare the high-gain reset signal hcg_rst with the reset ramp voltage signal and generate a high-gain reset pulse signal. The high-gain reset pulse signal is output to the counter circuit 30. The counter circuit 30 is configured to count the high-gain reset pulse signal in the same direction, and when the output of the comparison circuit 20 is flipped, the counter circuit 30 stops counting, the quantization of the high-gain reset signal hcg_rst is ended, where the second sub-digital code value is generated based on the counting of the counter circuit 30 and stored by the counter circuit 30 in the counter circuit 30.

Before the third exposure sampling time period, the inversion control circuit 40, upon receiving the mode selection signal mode_sel, is configured to output the inversion control signal trig_pulse to the counter circuit 30, the counter circuit 30 is then switched to the inversion mode and configured to invert the stored second sub-digital code value to the second digital code value as an initial state of the third exposure sampling time period. Then, the counter circuit 30 is restored to the counting mode and configured to quantize the high-gain pixel group signal hcg_sigl in the third exposure sampling time period. The comparison circuit 20 is configured to compare the high-gain pixel group signal hcg_sigl with the pixel ramp voltage signal and generate a high-gain pixel-group pulse signal. The high-gain pixel-group pulse signal is output to the counter circuit 30. The counter circuit 30 is configured to count the high-gain pixel-group pulse signal in the same direction based on the second digital code value, and when the output of the comparison circuit 20 is flipped, the counter circuit 30 stops counting, and the quantization of the high-gain pixel-group pulse signal is ended. The third sub-digital code value is generated based on the counting of the counter circuit 30, where the third sub-digital code value is a difference between the digital code values corresponding to the high-gain pixel group signal hcg_sigl and the high-gain reset signal hcg_rst, thus, the correlated double sampling is realized, the noise influence is reduced and the imaging quality is improved.

Then, the counter circuit 30 is reset again. Before the fourth exposure sampling time period, the storage circuit 50, upon receiving the write-back control signal rewrite_en, is configured to write back the stored second sub-digital code value to the counter circuit 30 again. In the meantime, the counter circuit 30, upon receiving the inversion control signal trig_pulse, is configured to invert the written-back second sub-digital code value to generate a second digital code value. The second digital code value is served as an initial state of the fourth exposure sampling time period. Then, the counter circuit 30 is restored to the counting mode and configured to quantize the high-gain image signal hcg_sig in the fourth exposure sampling time period. The comparison circuit 20 is configured to compare the high-gain image signal hcg_sig with the pixel ramp voltage signal and generate a high-gain image pulse signal. The high-gain image pulse signal is output to the counter circuit 30. The counter circuit 30 is configured to count the high-gain image pulse signal in the same direction based on the second digital code value, and when the output of the comparison circuit 20 is flipped, the counter circuit 30 stops counting, and the quantization of the high-gain image pulse signal is ended. The fourth sub-digital code value is generated based on the counting of the counter circuit 30, where the fourth sub-digital code value is a difference between the digital code values corresponding to the high-gain image signal hcg_sig and the high-gain reset signal hcg_rst, thus, the correlated double sampling is realized, the noise influence is reduced and the imaging quality is improved.

Then, the counter circuit 30 is reset again, and before the second exposure sampling time period, the storage circuit 50, upon receiving the write-back control signal rewrite_en, is configured to write back the stored first sub-digital code value to the counter circuit 30. In the meantime, the counter circuit 30, upon receiving the inversion control signal trig_pulse, is configured to invert the written-back first sub-digital code value to generate a fourth digital code value. The fourth digital code value is served as an initial state of the second exposure sampling time period. Then, the counter circuit 30 is restored to the counting mode and configured to quantize the low-gain image signal lcg_sig in the second exposure sampling time period. The comparison circuit 20 is configured to compare the low-gain image signal lcg_sig with the pixel ramp voltage signal and generate a low-gain image pulse signal. The low-gain image pulse signal is output to the counter circuit 30. The counter circuit 30 is configured to count the low-gain image pulse signal in the same direction based on the fourth digital code value, and when the output of the comparison circuit 20 is flipped, the counter circuit 30 stops counting, and the quantization of the low-gain image pulse signal is ended. The fifth digital code value is generated based on the counting of the counter circuit 30, where the fifth digital code value is a difference between the digital code values corresponding to the low-gain image signal lcg_sig and the low-gain reset signal lcg rst, thus, the correlated double sampling is realized, the noise influence is reduced and the imaging quality is improved.

In the meantime, the third sub-digital code value, the fourth sub-digital code value and the fifth digital code value obtained by the three quantizations are finally stored in the storage circuit 50, and read out to the corresponding control circuit 3 according to the readout control signal. The image information is determined by the control circuit 3 according to the third sub-digital code value, the fourth sub-digital code value and the fifth digital code value, and the automatic focus in the high conversion gain mode is achieved, which improves the imaging quality and user experiences.

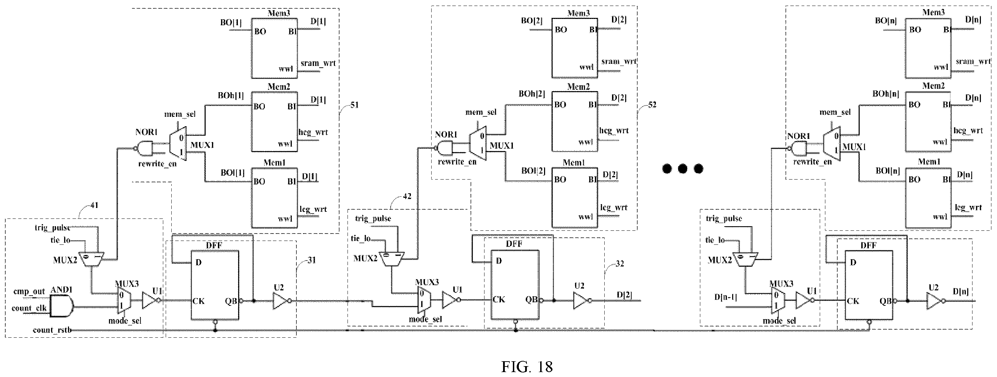

Corresponding to the signal input and output logic of the above-mentioned Embodiment 9 and Embodiment 10, as shown in FIG. 18, optionally, the counter circuit 30 includes a first counter unit 31 to an n-th counter unit.

The storage circuit 50 includes n storage units, one storage unit is respectively connected to a counter unit and an inversion control circuit 40.

Each storage unit includes a first memory Mem1, a second memory Mem2, a third memory Mem3, a NAND gate NOR1 and a first two-to-one data selector MUX1.

An input end of the first memory Mem1, an input end of the second memory Mem2 and an input end of the third memory Mem3 are simultaneously connected to a corresponding counter unit. An output end of the first memory Mem1 is connected to a first input end of the first two-to-one data selector MUX1. An output end of the second memory Mem2 is connected to a second input end of the one-to-two data selector MUX1. A control end of the first two-to-one data selector MUX1 is configured for an input of the write-back selection signal mem_sel. An output end of the first two-to-one data selector MUX1 is connected to a first input end of the NAND gate NOR1. A second input end of the NAND gate NOR1 is configured for an input of the write-back control signal rewrite_en, and the NAND gate NOR1 constitutes an output end of the storage circuit 50.

The first memory Mem1 is configured to store a corresponding one-bit count value of the first sub-digital code value.

The second memory Mem2 is configured to store a corresponding one-bit count value of the second sub-digital code value.

The first memory Mem1, the second memory Mem2 and the third memory Mem3 are also configured to respectively store a corresponding one-bit count value of three digital code value generated in sequence in three exposure samplings.

In this embodiment, compared with the circuit structure adopted in Embodiment 7 and Embodiment 8, the storage circuit 50 includes three memories and a first-to-one data selector MUX1. The n first memories Mem1 are configured to respectively store n bits of count values of the first sub-digital code value corresponding to the low-gain reset signal lcg_rst during the reset sampling time period. The n second memories Mem2 are configured to respectively store the n bits of count values of the second sub-digital code value corresponding to the high-gain reset signal hcg_rst during the reset sampling time period.

In the meantime, either the automatic focusing is realized in the low-gain mode or in the high-gain mode, before the corresponding exposure sampling time period, the corresponding write-back selection signal mem_sel is output to the first-to-one data selector MUX1 according to the first sub-digital code value or the second sub-digital code value that needs to be written back, so as to select the first sub-digital code value or the second sub-digital code value to be written back to the n counter units via the inversion control circuit 40.

The n counter units are configured to count the pulse signal input in the reset sampling time period and the exposure sampling time period and generate the corresponding digital code values.

After each exposure sampling time period, the three digital code values obtained by quantization are finally stored in the first memories Mem1, the second memories Mem2 and the third memories Mem3 respectively. For example, in case that the readout circuit 1 is suitable for realizing autofocus under low conversion gain, then the third digital code value, the fifth sub-digital code value and the sixth sub-digital code value are respectively obtained by the three exposure samplings, where, the n bits of count values of the third digital code value are respectively stored in n first memories Mem1, the n bits of count values of the fifth sub-digital code value are respectively stored in n second memories Mem2, and the n bits of count values of the sixth sub-digital code value are respectively stored in n third memories Mem3.

Or alternatively, in case that the readout circuit 1 is suitable for realizing autofocus under high conversion gain, then the third sub-digital code value, the fourth sub-digital code value and the fifth digital code value respectively obtained by the three exposure samplings where the n bits of count values of the third sub-digital code value are respectively stored in the n first memories Mem1, the n bits of count values of the fourth sub-digital code value are respectively stored in the n second memories Mem2, and the n bits of count values of the fifth digital code value are respectively stored in the n third memories Mem3, and the three memories are read out to the corresponding control circuit 3 according to the readout control signal, thereby the control circuit 3 is enabled to determine the image information according to the count code values of each storage circuit 50.

### Embodiment 11

Optimization and concretization on the basis of Embodiment 6. In another optional embodiment, the image sensor includes a pixel array 100, each pixel array 100 includes pixel units arranged in an array, and each readout circuit 1 of the image sensor is connected to a plurality of pixel units arranged in a column, and the pixel unit includes four sub-pixels arranged in a 2×2 manner, where two sub-pixels constitute a pixel group and are controlled to output a reset signal or a pixel signal simultaneously.

The reset sampling time period includes a first reset sampling time period and a second reset sampling time period following immediately the first reset sampling time period, and the at least one reset pulse signal includes a high-gain reset pulse signal and a low-gain reset pulse signal.

The first pixel pulse signal includes a first pixel-group pulse signal corresponding to a simultaneous exposure of pixel groups in a high-gain mode and a first image pulse signal corresponding to a simultaneous exposure of sub-pixels in the pixel units under the high-gain mode.

The second pixel pulse signal includes a second pixel-group pulse signal corresponding to a simultaneous exposure of pixel groups in a low-gain mode and a second image pulse signal corresponding to a simultaneous exposure of sub-pixels in the pixel units under the low-gain mode.

The first exposure sampling time period includes a third exposure sampling time period and a fourth exposure sampling time period following immediately the third exposure sampling time period.

The second exposure sampling time period includes a fifth exposure sampling time period and a sixth exposure sampling time period following immediately the fifth exposure sampling time period.

The first digital code value includes a first sub-digital code value and a second sub-digital code value.

The counter circuit 30 is configured to: count the low-gain reset pulse signal in the first reset sampling time period to generate the first sub-digital code value; and count the high-gain reset pulse signal to generate the second sub-digital code value in the second reset sampling time period.

The third digital code value includes a third sub-digital code value and a fourth sub-digital code value.

The counter circuit 30 is also configured to: count the first pixel-group pulse signal based on the second digital code value and store a counting result as the third sub-digital code value in the third exposure sampling time period; and count the first image pulse signal based on the second digital code value and store a counting result as the fourth sub-digital code value in the fourth exposure sampling time period.

The fifth digital code value includes a fifth sub-digital code value and a sixth sub-digital code value.

The counter circuit 30 is also configured to: count the second pixel-group pulse signal based on the fourth digital code value and store a counting result as the fifth sub-digital code value in the fifth exposure sampling time period; and count the second image pulse signal based on the fourth digital code value and store a counting result as the sixth sub-digital code value in the sixth exposure sampling time period.

The storage circuit 50 is connected to the counter circuit 30 and configured to store the first sub-digital code value and the second sub-digital code value. Before the fourth exposure sampling time period, the storage circuit 50 is configured, in response to a triggering of the write-back control signal rewrite_en, to write back the second sub-digital code value to the counter circuit 30, and before the fifth exposure sampling time period and the sixth exposure sampling time period, the storage circuit 50 is configured, in response to a triggering of the write-back control signal rewrite_en, to write back the first sub-digital code value to the counter circuit 30.

The inversion control circuit 40 is connected to the counter circuit 30 and the storage circuit 50. Before each exposure sampling time period, the inversion control circuit 40 is configured, in response to a triggering of the inversion control signal trig_pulse, to control the counter circuit 30 to invert the stored second sub-digital code value to generate the second digital code value, and to invert the first sub-digital code value to generate the fourth digital code value.

In this embodiment, the readout circuit 1 is suitable for realizing automatic focusing under both high and low conversion gains. The reset pulse signal includes the high-gain reset pulse signal and the low-gain reset pulse signal. The first pixel pulse signal includes the high-gain pixel-group pulse signal corresponding to the simultaneous exposure of the pixel groups in the high-gain mode and the high-gain image pulse signal corresponding to the simultaneous exposure of the sub-pixels in the pixel units under the high-gain mode. The second pixel pulse signal includes the low-gain image pulse signal. The second pixel pulse signal includes the low-gain pixel-group pulse signal corresponding to the simultaneous exposure of the pixel groups in the low-gain mode and the low-gain image pulse signal corresponding to the simultaneous exposure of the sub-pixels in the pixel units under the low-gain mode.

With reference to FIGS. 16 and 17, in the first reset sampling time period, the comparison circuit 20 is configured to compare the low-gain reset signal leg_rst with the reset ramp voltage signal and generate a low-gain reset pulse signal. The low-gain reset pulse signal is input to the counter circuit 30. The counter circuit 30 is configured to count up or down the low-gain reset pulse signal, and when the output of the comparison circuit 20 is flipped, the counter circuit 30 stops counting, the quantization of the low-gain reset signal lcg_rst is ended, where the first sub-digital code value is generated based on the counting of the counter circuit 30 and written by the counter circuit 30 into the storage circuit 50.

Before the second reset sampling time period, the counter circuit 30 is reset, and during the second reset sampling time period, the comparison circuit 20 is configured to compare the high-gain reset signal hcg_rst with the reset ramp voltage signal and generate a high-gain reset pulse signal. The high-gain reset pulse signal is output to the counter circuit 30. The counter circuit 30 is configured to count the high-gain reset pulse signal in the same direction, and when the output of the comparison circuit 20 is flipped, the counter circuit 30 stops counting, the quantization of the high-gain reset signal hcg_rst is ended, where the second sub-digital code value is generated based on the counting of the counter circuit 30 and stored by the counter circuit 30 in the counter circuit 30.

Before the third exposure sampling time period, the inversion control circuit 40, upon receiving the mode selection signal mode_sel, is configured output the inversion control signal trig_pulse to the counter circuit 30, the counter circuit 30 is then switched to the inversion mode and configured to invert the stored second sub-digital code value to the second digital code value as an initial state of the third exposure sampling time period. Then, the counter circuit 30 is restored to the counting mode and configured to quantize the high-gain pixel group signal hcg_sigl in the third exposure sampling time period. The comparison circuit 20 is configured to compare the high-gain pixel group signal hcg_sigl with the pixel ramp voltage signal and generate a high-gain pixel-group pulse signal. The high-gain pixel-group pulse signal is output to the counter circuit 30. The counter circuit 30 is configured to count the high-gain pixel-group pulse signal in the same direction based on the second digital code value, and when the output of the comparison circuit 20 is flipped, the counter circuit 30 stops counting, the quantization of the high-gain pixel-group pulse signal is ended. The third sub-digital code value is generated based on the counting of counter circuit 30, where the third sub-digital code value is a difference between the digital code values corresponding to the high-gain pixel group signal hcg_sigl and the high-gain reset signal hcg_rst, thus, the correlated double sampling is realized, the noise influence is reduced and the imaging quality is improved.

Then, the counter circuit 30 is reset again. Before the fourth exposure sampling time period, the storage circuit 50, upon receiving the write-back control signal rewrite_en, is configured to write back the stored second sub-digital code value to the counter circuit 30 again. In the meantime, the counter circuit 30, upon receiving the inversion control signal trig_pulse, is configured to invert the written-back second sub-digital code value to generate the second digital code value. The second digital code value is served as an initial state of the fourth exposure sampling time period. Then, the counter circuit 30 is restored to the counting mode and configured to quantize the high-gain image signal hcg_sig in the fourth exposure sampling time period. The comparison circuit 20 is configured to compare the high-gain image signal hcg_sig with the pixel ramp voltage signal and generate a high-gain image pulse signal. The high-gain image pulse signal is output to the counter circuit 30. The counter circuit 30 is configured to count the high-gain image pulse signal in the same direction based on the second digital code value, and when the output of the comparison circuit 20 is flipped, the counter circuit 30 stops counting, and the quantization of the high-gain image pulse signal is ended. The fourth sub-digital code value is generated based on the counting of the counter circuit 30, where the fourth sub-digital code value is a difference between the digital code values corresponding to the high-gain image signal hcg_sig and the high-gain reset signal hcg_rst, thus, the correlated double sampling is realized, the noise influence is reduced and the imaging quality is improved.

Before the fifth exposure sampling time period, the storage circuit 50, upon receiving the write-back control signal rewrite_en, is configured to write back the stored first sub-digital code value to the counter circuit 30. In the meantime, the counter circuit 30, upon receiving the inversion control signal trig_pulse, is configured to invert the written-back first sub-digital code value to generate a fourth digital code value. The fourth digital code value is served as an initial state of the fifth exposure sampling time period. Then, the counter circuit 30 is restored to the counting mode and configured to quantize the low-gain pixel group signal lcg_sigl in the fifth exposure sampling time period. The comparison circuit 20 is configured to compare the low-gain pixel group signal lcg_sigl with the pixel ramp voltage signal and generate a low-gain pixel-group pulse signal. The low-gain pixel-group pulse signal is output to the counter circuit 30. The counter circuit 30 is configured to count the low-gain pixel-group pulse signal in the same direction based on the fourth digital code value, and when the output of the comparison circuit 20 is flipped, the counter circuit 30 stops counting, and the quantization of the low-gain pixel-group pulse signal is ended. The fifth sub-digital code value is generated based on the counting of the counter circuit 30, where the fifth sub-digital code value is a difference between the digital code values corresponding to the low-gain pixel group signal lcg_sigl and the low-gain reset signal lcg rst, thus, the correlated double sampling is realized, the noise influence is reduced and the imaging quality is improved.

Then, the counter circuit 30 is reset again. Before the sixth exposure sampling time period, the storage circuit 50, upon receiving the write-back control signal rewrite_en, is configured to write back the stored first sub-digital code value to the counter circuit 30 again. In the meantime, the counter circuit 30, upon receiving the inversion control signal trig_pulse, is configured to invert the written-back first sub-digital code value to generate a fourth digital code value. The fourth digital code value is served as an initial state of the sixth exposure sampling time period. Then, the counter circuit 30 is restored to the counting mode and configured to quantize the low-gain image signal lcg_sig in the sixth exposure sampling time period. The comparison circuit 20 is configured to compare the low-gain image signal lcg_sig with the pixel ramp voltage signal and generate a low-gain image pulse signal. The low-gain image pulse signal is output to the counter circuit 30. The counter circuit 30 is configured to count the low-gain image pulse signal in the same direction based on the fourth digital code value, and when the output of the comparison circuit 20 is flipped, the counter circuit 30 stops counting, and the quantization of the low-gain image pulse signal is ended. The sixth sub-digital code value is generated based on the counting of the counter circuit 30, where the sixth sub-digital code value is a difference between the digital code values corresponding to the low-gain image signal lcg_sig and the low-gain reset signal lcg rst, thus, the correlated double sampling is realized, the noise influence is reduced and the imaging quality is improved.

At the same time, the third sub-digital code value, the fourth sub-digital code value, the fifth sub-digital code value and the sixth sub-digital code value obtained by the four quantizations are finally stored in the storage circuit 50, and read out to the corresponding control circuit 3 according to the readout control signal. The image information is determined by the control circuit 3 according to the third sub-digital code value, the fourth sub-digital code value and the fifth digital code value, and the automatic focus in the high conversion gain mode is achieved, which improves the imaging quality and user experiences.

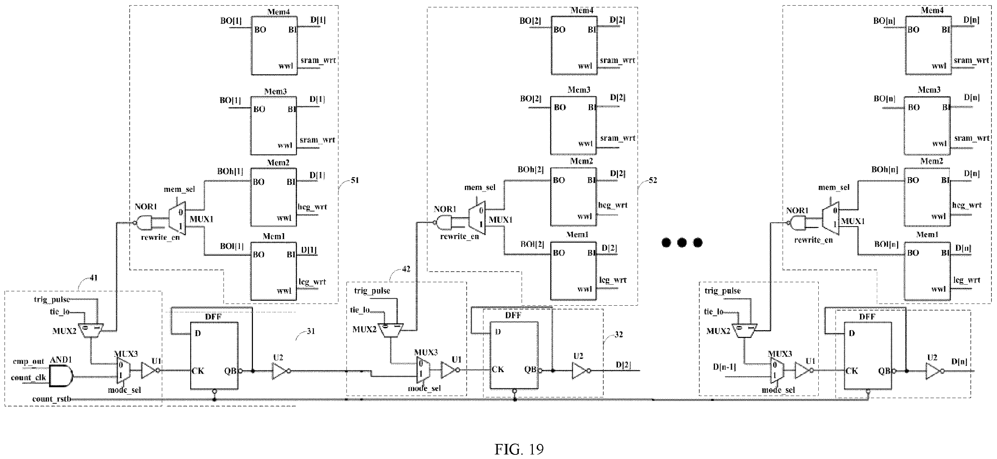

Corresponding to the signal input and output logic of the above-mentioned Embodiment 11, as shown in FIG. 19, optionally, the counter circuit 30 includes a first counter unit 31 to an n-th counter unit.

The storage circuit 50 includes n storage units, one storage unit is respectively connected to a counter unit and an inversion control circuit 40.

Each storage unit includes a first memory Mem1, a second memory Mem2, a third memory Mem3, a fourth memory Mem4, a NAND gate NOR1 and a first two-to-one data selector MUX1.

An input end of the first memory Mem1, an input end of the second memory Mem2 and an input end of the third memory Mem3 are simultaneously connected to a corresponding counter unit. An output end of the first memory Mem1 is connected to a first input end of the first two-to-one data selector MUX1, and an output end of the second memory Mem2 is connected to a second input end of the first two-to-one data selector MUX1. A control end of the first two-to-one data selector MUX1 is configured for an input of the write-back selection signal mem_sel. An output end of the first two-to-one data selector MUX1 is connected to a first input end of the NAND gate NOR1, a second input end of the NAND gate NOR1 is configured for an input of the write-back control signal rewrite_en, and the NAND gate NOR1 constitutes an output end of the storage circuit 50.

The first memory Mem1 is configured to store a corresponding one-bit count value of the first sub-digital code value.

The second memory Mem2 is configured to store a corresponding one-bit count value of the second sub-digital code value.

The first memory Mem1, the second memory Mem2, the third memory Mem3 and the fourth memory Mem4 are also configured to respectively store a corresponding one-bit count value of the third sub-digital code value, a corresponding one-bit count value of the fourth sub-digital code value, a corresponding one-bit count value of the fifth sub-digital code value and a corresponding one-bit count value of the sixth sub-digital code value.

In this embodiment, compared with the circuit structure adopted in Embodiment 9and Embodiment 10, the storage circuit 50 includes four memories. The n first memories Mem1 are configured to respectively store the n bits of count values of the first sub-digital code value corresponding to the low-gain reset signal lcg rst in the reset sampling time period, and the n second memories Mem2 are configured to respectively store the n bits of count values of the second sub-digital code value corresponding to the high-gain reset signal hcg_rst in the reset sampling time period.

In the meantime, when the automatic focusing is realized in the low-gain mode or the high-gain mode, before the corresponding exposure sampling time period, a corresponding write-back selection signal mem_sel is output to the first two-to-one data selector MUX1 according to the first sub-digital code value or the second sub-digital code value that needs to be written back, so as to select the first sub-digital code value or the second sub-digital code value to be written back to the n counter units via the inversion control circuit 40.

The n bit counter units are configured to count the pulse signal input in the reset sampling time period and the exposure sampling time period and generate the corresponding digital code values.

After each exposure sampling time period, the four digital code values obtained by quantization are finally stored in the first memories Mem1, the second memories Mem2, the third memories Mem3 and the fourth memories Mem4 respectively, and read out by four memories to the corresponding control circuit 3 according to the readout control signal, thus, the control circuit 3 is enabled to determine the image information according to the count code values of each storage circuit 50.

Optionally, in some embodiments, the corresponding digital code value may be read out in advance through the memory and then reset, so that the memory read out in advance can be reused as a memory for the subsequent digital code value, which can further reduce the number of memories and reduce the occupied area.

### Embodiment 12

Optimization and concretization on the basis of Embodiments 6 to 11. Optionally, as shown in FIGS. 15, 18 and 19, the counter circuit 30 includes a first counter unit 31 to an n-th counter unit.

The inversion control circuit 40 includes n selection circuits.

A first input end of the i-th selection circuit is configured for an input of an inversion control signal trig_pulse. A second input end of the first selection circuit 41 is configured for an input of a clock signal count_clk. Second input ends of a second selection circuit 42 to the n-th selection circuit are respectively connected to an output end of an (i-1)-th counter unit. A third input end of the i-th selection circuit is configured for an input of a low-level signal. A fourth input end of the first selection circuit 41 is configured for an input of the output signal count_out of the comparison circuit 20. An output end of the i-th selection circuit is connected to an input end of the i-th level counter unit, where i is 1, 2, ..., n.

The i-th selection circuit is configured, in response to the triggering of the mode selection signal mode_sel or the write-back control signal rewrite_en, to output signals received at the first input end, the second input end or the third input end of the i-th selection circuit.

In this embodiment, the inversion control circuit 40 is configured to realize the transmission of the inversion control signal trig_pulse, the written-back digital code value, and the clock signal count_clk.

Each selection circuit is connected to a front end of a counter unit and configured to output a corresponding signal received at its input end to its own output end according to the received mode selection signal mode_sel. Before quantization, each counter unit is reset, and in the reset sampling time period, the pixel unit is configured to output a reset signal to the comparison circuit 20. The comparison circuit 20 is configured to compare the reset signal with the ramp voltage signal and generate a reset pulse signal. The reset pulse signal is output to the first selection circuit 41. Each selection circuit, upon receiving the mode selection signal mode_sel of a first level, is configured to trigger a connection between its own second input and output end. The first selection circuit 41 is configured to output the clock signal count_clk to the first counter unit 31. The subsequent selection circuits are respectively configured to select and output a count value of a previous counter unit to a next counter unit. Each counter unit is configured to store a first count value in the respective counter unit, and the first count values of all counter units are combined to generate a first digital code value.

In an inversion mode of the exposure sampling time period, the mode selection signal mode_sel is switched to a second level, each selection circuit is configured to output the inversion control signal trig_pulse at the first input end to the counter unit at a back end, each counter unit is switched to the inversion mode and configured to invert the first count value stored in itself to a second count value or a fourth digital code value, and then, the mode selection signal mode_sel is switched to the first level again, the inversion control signal trig_pulse is also switched its level state, and each counter unit is switched to a counting mode.

In a write-back mode of the exposure sampling time period, the storage circuit 50, upon receiving the write-back control signal rewrite_en, is configured to write back the stored first digital code value to the n selection circuits, and the written-back first digital code value is then written back by the n selection circuits to the n counter units.

Further referring to FIGS. 15, 18 and 19. Optionally, the first selection circuit 41 includes an AND gate AND1, a second two-to-one data selector MUX2, a third two-to-one data selector MUX3 and a first inverter U1.

A first input end of the AND gate AND1 is configured for an input of the clock signal count_clk. A second input end of the AND gate AND1 is configured for an input of an output signal count_out of the comparison circuit 20. A first input end of the second two-to-one data selector MUX2 is configured for an input of the inversion control signal trig_pulse. An output end of the AND gate AND1 is connected to a second input end of the two-to-one data selector. A second input end of the second two-to-one data selector MUX2 is configured for an input of a low-level signal tie_lo. A control end of the second two-to-one data selector MUX2 is connected to an output end of the storage circuit 50. An output end of the second two-to-one data selector MUX2 is connected to a first input end of the third two-to-one data selector MUX3. A second input end of the third two-to-one data selector MUX3 is configured for an input of the clock signal count_clk or a value output from a previous counter unit. A control end of the third two-to-one data selector MUX3 is configured for an input of the mode selection signal mode_sel. An output end of the third two-to-one data selector MUX3 is connected to an input end of the first inverter U1. An output end of the first inverter U1 is configured to output a corresponding one of the inversion control signal trig_pulse, the clock signal count_clk and the low-level signal tie_lo.

From the second selection circuit 42 to the n-th selection circuit, each selection circuit includes a second two-to-one data selector MUX2, a third two-to-one data selector MUX3 and a first inverter U1.

A first input end of the second two-to-one data selector MUX2 is configured for an input of the inversion control signal trig_pulse. A second input end of the second two-to-one data selector MUX2 is configured for an input of a low-level signal tie_lo. A control end of the second two-to-one data selector MUX2 is connected to an output end of the storage circuit 50. An output end the second two-to-one data selector MUX2 is connected to a first input end of the third two-to-one data selector MUX3. A second input end of the third two-to-one data selector MUX3 is configured for an input of the clock signal count_clk or a value output from a previous counter unit. A control end of the third two-to-one data selector MUX3 is configured for an input of the mode selection signal mode_sel. An output end of the third two-to-one data selector MUX3 is connected to an input end of the first inverter U1. An output end of the first inverter U1 is configured to output a corresponding one of the inversion control signal trig_pulse, the clock signal count_clk, the low-level signal tie_lo and the value output from the previous counter unit.

Further referring to FIGS. 6, 8, 15, 18 and 19, the counter unit includes a D flip-flop DFF and a second inverter U2, or alternatively, the counter unit includes a D flip-flop DFF.

In this embodiment, in case that an inverting output pin of the D flip-flop DFF is connected to the second inverter U2, and the second inverter U2 is served as an output end of the counter unit, then the counter unit constitutes an up counter. In case that a non-inverting output pin of the D flip-flop DFF constitutes the output end of the counter unit, then the counter unit constitutes a down counter. By inverting and writing back the reset signal, the counter unit, when continuously quantizing the reset signal and the pixel signal, does not need to switch between up-counting and down-counting, and does not need to be provided with an additional holding circuit. Compared with the traditional counter circuit 30, the number of transistors can be reduced, and then the layout area is reduced and the routing is optimized, thereby the purpose of reducing the power consumption is achieved.

Referring to FIGS. 13 and 14, taking the up counting as an example, when the selection circuit and the counter unit are applied to the ADAF mode, the timing of a complete quantization cycle in the ADAF mode is as follows:
At time t0-t1, count__rstb is switched to a low level, and values in all D flip-flops DFF are reset (all outputs become 0).

At time t2, a quantization on the reset signal starts, at this time, the output signal count_out of the comparison circuit 20 is switched to a high level. After the clock signal count_clk and the high level are operated via the AND gate AND1, the clock signal count_clk is output to the second input of the third two-to-one data selector MUX3. At this time, the mode selection signal mode_sel is at a high level, and the clock signal count_clk is selected to be output to the first inverter U1 and output to the first D flip-flop DFF. Each D flip-flop DFF is controlled to count up under the action of the clock signal count_clk.

At time t3, the output of the comparison circuit 20 is flipped, the counting stops, and the quantization of the reset signal is ended. Each count value of the first digital code value as a quantization result of the reset signal is stored in the corresponding D flip-flop DFF, and the first count values output from all second inverter U2 are combined to generate the first digital code value.

At time t4-t5, a readout control signal is switched to a high level, and a first quantization result is stored in the first memories Mem1.

At time t5, the mode selection signal mode_sel is switched to a low level, and each counter unit is switched to the inversion mode.

At time t6, the inversion control signal trig_pulse is switched to a low level, and via the second two-to-one data selector MUX2 and the third two-to-one data selector MUX3, a rising edge is generated at the clock input of each D flip-flop DFF, a digital code of the first quantization result stored in each D flip-flop DFF is inverted as an initial state before a second quantization.

At time t7, the mode selection signal mode_sel is switched to a high level, and each counter unit is restored to the counting mode. At time t8, the inversion control circuit 40 is switched to a high level.

At time t9, a quantization on the pixel group signal Vsigl starts from the initial state. At time t10, the output of the comparison circuit 20 is flipped, the counting stops, the quantization of the pixel group signal Vsigl is ended, and a third digital code value as a result of a difference value between the pixel group signal Vsigl and the reset signal is stored in the D flip-flops DFF.

At time t11-t12, sram_wrt is enabled, and a final quantization result is stored in the second memories Mem2, and then read out.

At time t12-t13, count_rstb is switched to a low level, and the values in all D flip-flops DFF are reset (all outputs become 0).

At time t13, the mode selection signal mode_sel is switched to a low level, the write-back control signal rewrite_en is switched to a high level, and each counter unit is switched to a write-back mode.

At time t14, the inversion control signal trig_pulse is switched to a low level, and via the second two-to-one data selector MUX2 and the third two-to-one data selector MUX3, a rising edge is generated at the clock input of the D flip-flop DFF. The first digital code value stored in the first memories Mem1 is written into the n counter units and inverted, as an initial state before a quantization on the image signal Vsig.

At time t15, the mode selection signal mode_sel is switched to a high level, and each counter unit is restored to the counting mode. At time t16, the inversion control signal trig_pulse is switched to a high level.

At time t17, the quantization on the image signal Vsig starts from the initial state. At time t18, the output of the comparison circuit 20 is flipped, the counting stops, the quantization of the image signal Vsig is ended, and a difference value between the image signal Vsig and the reset signal, that is, an image quantization value of a correlated double sampling, is stored in the D flip-flops DFF.

At time t19-t20, the readout control signal is enabled, and a final quantization result is stored in the first memories Mem1, and then read out.

Referring to FIGS. 13 and 15, when the selection circuit is applied to a PGHDR mode, the timing of a complete quantization cycle in the PGHDR mode is as follows:
At time t0-t1, count_rstb is switched to a low level, values in all D flip-flops DFF are reset (all outputs become 0).

At time t2, a quantization on the low-gain reset signal lcg rst starts, at this time, the output signal count_out of the comparison circuit 20 is switched to a high level. After the clock signal count_clk and the high level are operated via the AND gate AND1, the clock signal count_clk is output to the second input of the third two-to-one data selector MUX3. At this time, the mode selection signal mode_sel is at a high level, and the clock signal count_clk is selected to be output to the first inverter U1 and output to the first D flip-flop DFF. Each D flip-flop DFF is controlled to count up under the action of the clock signal count_clk.

At time t3, the output of the comparison circuit 20 is flipped, the counting stops, the quantization of the low-gain reset signal lcg rst is ended, and a first sub-digit code as a quantization result of the low-gain reset signal lcg_rst is stored in each D flip-flop DFF.

At time t4-t5, a readout control signal is switched to a high level, and the first sub-digital code is stored in the first memories Mem1.

At time t5-t6, count_rstb is switched to a low level, and the values in all D flip-flops DFF are reset (all outputs become 0).

At time t7, a quantization on the high-gain reset signal hcg_rst starts from the initial state. At time t8, the output of the comparison circuit 20 is flipped, the counting stops, the quantization of the high-gain reset signal hcg_rst is ended, and a second sub-digital code of the high-gain reset signal hcg_rst is stored in each D flip-flop DFF.

At time t9, the mode selection signal mode_sel is switched to a low level, and each counter unit is switched to the inversion mode. At time t10, the inversion control signal trig_pulse is switched to a low level, and via the second two-to-one data selector MUX2 and the third two-to-one data selector MUX3 is output to the clock input pin of the D flip-flop DFF, where a rising edge is generated, and the digital code of the second quantization result stored in each D flip-flop DFF is inverted to a second digital code value, the second digital code value is served as an initial state before a second quantization.

At time t11, the mode selection signal mode_sel is switched to a high level, and each counter unit is restored to the counting mode. At time t12, the mode selection signal mode_sel is switched to a high level.

At time t13, a quantization on the high-gain image signal hcg_sig starts from the initial state. At time t14, the output of the comparison circuit 20 is flipped, the counting stops, the quantization of the high-gain image signal hcg_sig is ended, and a difference value between the high-gain image signal hcg_sig and the reset signal, that is, an image quantization value of a correlated double sampling under high conversion gain, is stored in the D flip-flops DFF. At time t15-t16, sram_wrt is enabled, and the final quantization result is stored in the second memories Mem2, and then read out.

At time t16-t17, count_rstb is switched to a low level, the values in all D flip-flops DFF are reset (all outputs become 0). At time t17, the mode selection signal mode_sel is switched to a low level, the write-back control signal rewrite_en is switched to a high level, and the counter unit is switched to a write-back mode.

At time t18, the inversion control signal trig_pulse is switched to a low level, and a rising edge is generated at the clock input of the D flip-flop DFF. The first sub-digital code value corresponding to the low-gain reset signal lcg rst stored in the first memories Mem1 is written back to the counter units and inverted, as an initial state before a quantization on the low-gain image signal lcg_sig.

At time t19, the mode selection signal mode_sel is switched to a high level, and each counter unit is restored to the counting mode. At time t20, the inversion control signal trig_pulse is switched to a high level.

At time t21, the quantization on the low-gain image signal lcg_sig starts from the initial state. At time t22, the output of the comparison circuit 20 is flipped, the counting stops, and the quantization of the low-gain image signal lcg_sig is ended, and a difference value between the low-gain image signal lcg_sig and the reset signal, that is, an image quantization value of the correlated double sampling under low conversion gain, is stored in the D flip-flops DFF. At time t23-t24, the readout control signal is enabled, and the final quantization result is stored in the first memories Mem1, and then read out.

At this point, a complete quantization cycle is completed, and finally the image quantization value of the correlated double sampling under high conversion gain and the image quantization value of the correlated double sampling under low conversion gain are obtained.

And when the selection circuit is applied to implement the ADAF mode under low conversion gain, the timing of a complete quantization cycle is shown in FIG. 16.

At time t0-t1, count__rstb is switched to a low level, and values in all D flip-flops DFF are reset (all outputs become 0).

At time t2, a quantization on the low-gain reset signal lcg_rst starts, and the counter is controlled to count up under the action of the high-speed clock count_clk. At time t3, the output of the comparison circuit 20 is flipped, the counting stops, the quantization of the low-gain reset signal lcg rst is ended, and the first sub-digit code value as a quantization result of the low-gain reset signal lcg rst is stored in the D flip-flops DFF.

At time t4-t5, a readout control signal is switched to a high level, and the first quantization result is stored in the first memories Mem1.

At time t5-t6, count_rstb is switched to a low level, and the values in all D flip-flops DFF are reset (all outputs become 0).

At time t7, a quantization on the high-gain reset signal hcg_rst starts from the initial state. At time t8, the output of the comparison circuit 20 is flipped, the counting stops, the quantization of the high-gain reset signal hcg_rst is ended, and the second sub-digital code value of the high-gain reset signal hcg_rst is stored in the D flip-flops DFF.

At time t9, the mode selection signal mode_sel is switched to a low level, and connections among the counters are disconnected. At time t10, the inversion control signal trig_pulse is switched to a low level, and a rising edge is generated at the clock input of the D flip-flop DFF, and the second quantization result digital code stored in the D flip-flops DFF is inverted as an initial state before a third quantization.

At time t11, the mode selection signal mode_sel is switched to a high level, and the counter is restored to the counting mode. At time t12, the inversion control signal trig_pulse is switched to a high level.

At time t13, a quantization on the high-gain image signal hcg_sig starts from the initial state. At time t14, the output of the comparison circuit 20 is flipped, the counting stops, the quantization of the high-gain image signal hcg_sig is ended, and a difference value between the high-gain image signal hcg_sig and the high-gain reset signal hcg_rst, that is, an image quantization value of the correlated double sampling under high conversion gain is stored in the D flip-flops DFF.

At time t15, the write-back control signal rewrite_en and the mode selection signal mode_sel are respectively switched to a high level, the counter is switched to the write-back mode, and the first sub-digit code value stored in the first memories Mem1 is selected to be written back into the counter. At time t15-t16, sram_wrt is enabled, and the final quantization result is stored in the second memories Mem2, and then read out.

At time t16-t17, count_rstb is switched to a low level, and the values in all D flip-flops DFF are reset (all outputs become 0). At time t17, the mode selection signal mode_sel is switched to a low level, and the connections among the counters are disconnected. At time t18, the inversion control signal trig_pulse is switched to a low level, a rising edge is generated at the clock input of the D flip-flop DFF, and the first sub-digit code value corresponding to the low-gain reset signal lcg_rst stored in the first memory Mem1 is written back to the counter units and inverted as an initial state before a fourth quantization. At time t19, the mode selection signal mode_sel is switched to a high level, and the counter is restored to the counting mode. At time t20, the inversion control signal trig_pulse is switched to a high level.

At time t21, a quantization on the low-gain pixel group signal lcg_sigl starts from the initial state. At time t22, the output of the comparison circuit 20 is flipped, the counting stops, the quantization of the low-gain pixel group signal lcg_sigl is ended, and a difference value between the low-gain pixel group signal lcg_sigl and the low-gain reset signal lcg_rst, that is, a quantization value of the pixel group signal Vsigl of the correlated double sampling under low conversion gain, is stored in the D flip-flops DFF. At time t23-t24, hcg_wrt is enabled, and the final quantization result is stored in the third memories Mem3, and then read out.

At time t24-t25, count_rstb is switched to a low level, and the values in all D flip-flops DFF are reset (all outputs become 0). At time t25, the mode selection signal mode_sel is switched to a low level, and the connections among the counters are disconnected. At time t26, the inversion control signal trig_pulse is switched to a low level, a rising edge is generated at the clock input of the D flip-flop DFF, and the first digital code value stored in the first memories Mem1 is written back to the counters and inverted as an initial state before a fifth sub-quantization. At time t27, the mode selection signal mode_sel is switched to a high level, and the counter is restored to the counting mode. At time t28, the inversion control signal trig_pulse is switched to a high level.

At time t29, a quantization on the low-gain image signal lcg_sig starts from the initial state. At time t30, the output of the comparison circuit 20 is flipped, the counting stops, the quantization of the low-gain image signal lcg_sig is ended, and the difference value between the low-gain image signal lcg_sig and the low-gain reset signal lcg rst, that is, an image quantization value of the correlated double sampling under low conversion gain, is stored in the D flip-flop DFF. At t31-t32, lcg_wrt is enabled, and the final quantization result is stored in the first memories Mem1, and then read out.

At this point, a complete quantization cycle is completed, and the image quantization value of the correlated double sampling under high conversion gain, the pixel group quantization value of the correlated double sampling under low conversion gain, and the image quantization value of the correlated double sampling under low conversion gain are obtained in turn.

Similarly, in case that the selection circuit is applied to implement the ADAF mode under high conversion gain, or applied to implement the ADAF mode under both high and low conversion gains, the selection circuit is configured to select and output the corresponding inversion control signal trig_pulse or digital code value to the counter units according to the received corresponding mode selection signal mode_sel or the written-back digital code value, to enable the counter units to perform counting, inversion and other operations.

After each quantization, the corresponding digital code value is stored in the corresponding memories, and read out by the memories to the control circuit 3 according to the received readout control signal, so that the control circuit 3 is enabled to determine the image information according to each digital code value.

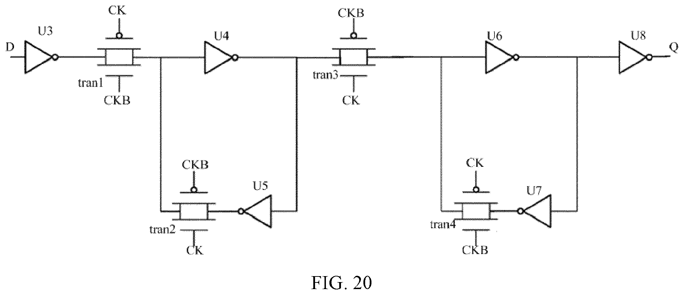

Herein, to realize the inversion function of the D flip-flop DFF in the above embodiment, as shown in FIG. 20, optionally, the D flip-flop DFF includes a third inverter U3, a fourth inverter U4, a fifth inverter U5, a sixth inverter U6, a seventh inverter U7, an eighth inverter U8, a first transmission gate tran1, a second transmission gate tran2, a third transmission gate tran3 and a fourth transmission gate tran4.

In this embodiment, the first transmission gate tran1, the fourth inverter U4, the fifth inverter U5 and the second transmission gate tran2 constitute a master latch, and the third transmission gate tran3, the sixth inverter U6, the seventh inverter U7 and the fourth transmission gate tran4 constitute a slave latch. The master latch is configured to stably latch and output an input value of the D flip-flop DFF. The slave latch is configured to stably latch and output an output value of the master latch. The third inverter U3 is configured to invert an input data signal and output the same to the master latch, the eighth inverter U8 is configured to invert the output value of the slave latch and output the same, when a rising edge is received at the clock signal count_clk pin of the D flip-flop DFF, the third inverter U3, the master latch, the slave latch and the eighth inverter U8 are configured to invert the latched value and output the same.

### Embodiment 13

An image sensor is also provided in the present application, as shown in FIG. 2, the image sensor includes a pixel array 100, a control circuit 3 and a plurality of readout circuit 1 of the image sensor. For specific structure of the readout circuit 1 of the image sensor, references may be made to the above embodiment. Since the image sensor adopts all the technical schemes of all the above embodiments, the image sensor provided here at least has all the beneficial effects brought by the technical schemes of the above embodiments, which will not be described one by one here. Herein, the pixel array 100 includes a plurality of pixel units arranged in an array.

Each of the readout circuits 1 of the image sensor is connected to a plurality of pixel units arranged in a column, and all of the readout circuits 1 of the image sensor are also connected to a control circuit 3.

In this embodiment, the image sensor generally includes the control circuit 3, the pixel array 100, the readout circuits 1, and may also include a clock generator and a digital I/O port. The pixel array 100 includes a plurality of pixel units arranged in an array, and a plurality of pixel units arranged in columns are connected in common. The control circuit 3 is configured to select pixel units in each row through a row selection signal, and output pixel signals of all rows to the readout circuits 1 in sequence. The plurality of pixel units arranged in columns are connected to a corresponding readout circuit 1. Each readout circuit 1 is configured to perform an analog-to-digital conversion and output a corresponding digital code value to the control circuit 3, so that the control circuit 3 is enabled to determine the image information according to the digital code values.

The pixel unit generally includes a photoelectric conversion element, a transmission transistor TX, a reset transistor RST, a source follower transistor SF and a row selection transistor SEL, where the photoelectric conversion element includes but is not limited to a photodiode PD, such as a Pin-type photodiode PD. Meanwhile, the number of the photoelectric conversion element, the transmission transistor TX, the reset transistor RST, the source follower transistor SF and the row selection transistor SEL may be one or more, that is, the structure of the pixel unit can be selected based on actual needs, and the specific structure is not limited here. As shown in FIG. 3, taking the basic pixel unit 2 as an example, the pixel unit 2 includes a photodiode PD, a transmission transistor TX, a reset transistor RST, a source follower transistor SF and a row selection transistor SEL, where a cathode of the photodiode PD is connected to a first end of the transmission transistor TX; a second end of the transmission transistor TX, a first end of the reset transistor RST and the controlled end of the source follower transistor SF are all coupled to the floating diffusion node; an anode of the photodiode PD is grounded; a second end of the reset transistor RST and a first end of the source follower transistor SF are both connected to the positive power supply VDD; a second end of the source follower transistor SF is connected to a first end of the row selection transistor SEL; and a second end of the row selection transistor SEL constitutes an output end of the pixel unit 2 and is configured to output a corresponding pixel signal.

The above embodiments are only used to illustrate rather than limiting the technical schemes of the present application. Although the present application has been described in detail with reference to the foregoing embodiments, it should be understood by persons of ordinary skills in the art that the technical schemes described in the foregoing embodiments may still be modified, or some of the technical features in the foregoing embodiments may be equivalently substituted. These modifications or substitutions do not cause the essence of the corresponding technical schemes to deviate from the spirit and scope of the technical schemes of the embodiments of the present application, and thus shall all be included within the protection scope of the present application.

## Claims

1. A readout circuit of an image sensor, comprising:
a ramp voltage circuit, configured to output a ramp voltage signal in a first quantization time period and a second quantization time period of a pixel unit respectively;
a comparison circuit, having a first input end connected to the pixel unit and a second input end connected to the ramp voltage circuit, and configured to compare a reset signal or a pixel signal output from the pixel unit with the ramp voltage signal and output a reset pulse signal or a pixel pulse signal;
a counter circuit, connected to the comparison circuit, and configured to count a first pulse signal in the first quantization time period and store a first digital code value; and count a second pulse signal based on a second digital code value in the second quantization time period and store a counting result as a third digital code value, wherein the first pulse signal and the second pulse signal are respectively the reset pulse signal and the pixel pulse signal, or the first pulse signal and the second pulse signal are respectively the pixel pulse signal and the reset pulse signal; and
an inversion control circuit, connected to the counter circuit, and configured, in response to a triggering of a mode selection signal, to output an inversion control signal between the first quantization time period and the second quantization time period, to enable the counter circuit, in response to a triggering of the inversion control signal, to invert the first digital code value to the second digital code value and store the second digital code value.

2. The readout circuit of the image sensor according to claim 1, wherein the counter circuit is configured to count the reset pulse signal in the first quantization time period and store the first digital code value, and count the pixel pulse signal based on the second digital code value in the second quantization time period and store the counting result as the third digital code value;
or alternatively, the counter circuit is configured to count the pixel pulse signal in the first quantization time period and store the first digital code value, and count the reset pulse signal based on the second digital code value in the second quantization time period and store the counting result as the third digital code value.

3. The readout circuit of the image sensor according to claim 1, wherein the counter circuit comprises a first counter unit to an n-th counter unit;
the inversion control circuit comprises n selection circuits, a first input end of an i-th selection circuit is configured for an input of an inversion control signal, a second input end of the first selection circuit is configured for an input of a clock signal, a third input end of the first selection circuit is configured for an input of an output signal of a comparator, second input ends of the second selection circuit to the n-th selection circuit are respectively connected to an output end of an (i-1)-th counter unit, an output end of the i-th selection circuit is connected to an input end of an i-th counter unit, wherein i is 1, 2,..n;
the i-th selection circuit is configured to output the inversion control signal or the clock signal in response to the mode selection signal;
the first counter unit to the n-th counter unit are configured to count the first pulse signal in the first quantization time period, and store a first count value in the first counter unit to the n-th counter unit respectively, and count values of the first counter unit to the n-th counter unit are combined to generate the first digital code value; and between the first quantization time period and the second quantization time period, the first counter unit to the n-th counter unit are respectively configured, in response to the inversion control signal, to invert the first count value as a second count value and store the same, and count values of the first counter unit to the n-th counter unit are combined to generate the second digital code value; and
the first counter unit to the n-th counter unit are respectively configured to count the second pulse signal based on the second count value in the second quantization time period, and store a counting result as a third count value, and count values of the first counter unit to the n-th counter unit are combined to generate the third digital code value.

4. The readout circuit of the image sensor according to claim 3, wherein the first selection circuit comprises an AND gate, a two-selection data selector and a first inverter;
a first input end of the AND gate is configured for an input of the clock signal, a second input end of the AND gate is configured for an input of the output signal of the comparator, a first input end of the two-selection data selector is configured for an input of the inversion control signal, an output end of the AND gate is connected to a second input end of the two-selection data selector, an output end of the two-selection data selector is connected to an input end of the first inverter, and an output end of the first inverter constitutes an output end of the first selection circuit; and
the second selection circuit to the n-th selection circuit each comprises a two-selection data selector and a first inverter, and from the second selection circuit to the n-th selection circuit, a first input end of each two-selection data selector is configured for an input of the inversion control signal, a second input end of each two-selection data selector is configured for an input of a value output from a previous counter unit, an output end of each two-selection data selector is connected to the input end of each first inverter, and an output end of each first inverter constitutes an output end of a corresponding selection circuit.

5. The readout circuit of the image sensor according to claim 3, wherein the readout circuit of the image sensor further comprises: a storage circuit,
wherein the storage circuit is connected to the counter circuit, and configured to store the third digital code value and to read out the third digital code value in response to a readout control signal;
the storage circuit comprises n memories; and
the n memories are respectively connected to the counter units in a one-to-one correspondence, and configured to respectively store a count value of a corresponding bit of the third digital code value.

6. The readout circuit of the image sensor according to claim 2, wherein the first quantization time period is a reset sampling time period, the second quantization time period is a first exposure sampling time period, and wherein at least one reset sampling time period and two pixel signals are provided;
the ramp voltage circuit is further configured to output the ramp voltage signal in each sampling time period;
the comparison circuit is further configured to compare the at least one reset signal or the two pixel signals output from the pixel unit with the ramp voltage signal, and output at least one reset pulse signal and two pixel pulse signals at intervals;
the counter circuit is further configured to count the at least one reset pulse signal in at least one reset sampling time period, and store a counting result as at least one first digital code value; count a first pixel pulse signal based on the second digital code value in a first exposure sampling time period, and store a counting result as the third digital code value; and count a second pixel pulse signal based on a fourth digital code value in a second exposure sampling time period, and store a counting result as a fifth digital code value;
the inversion control circuit is connected to the counter circuit and the storage circuit, and before each exposure sampling time period, the inversion control circuit is configured in response to the triggering of the mode selection signal, to output the inversion control signal to the counter circuit to trigger the counter circuit to invert a stored first digital code value to generate the second digital code value or the fourth digital code value;
the readout circuit of the image sensor also comprises a storage circuit; and
the storage circuit is connected to the counter circuit and configured to store the at least one first digital code value, and before the second exposure sampling time period, the storage circuit is configured, in response to a triggering of a write-back control signal, to write back one of the at least one first digital code value to the counter circuit.

7. The readout circuit of the image sensor according to claim 6, wherein the image sensor comprises a pixel array, each pixel array comprises pixel units arranged in an array, each readout circuit of the image sensor is connected to a plurality of pixel units arranged in a column, the pixel unit comprises at least four sub-pixels arranged in a 2×2 manner, wherein at least two sub-pixels constitute a pixel group and are controlled to simultaneously output a reset signal or a pixel signal;
the at least one reset signal is a reset signal generated when the pixel units are reset simultaneously; and
the first pixel pulse signal and the second pixel pulse signal are respectively one of a pixel-group pulse signal corresponding to a simultaneous exposure of pixel groups and an image pulse signal corresponding to a simultaneous exposure of sub-pixels in the pixel units.

8. The readout circuit of the image sensor according to claim 6, wherein the reset sampling time period comprises a first reset sampling time period and a second reset sampling time period, and the at least one reset pulse signal comprises a high-gain reset pulse signal and a low-gain reset pulse signal;
the first pixel pulse signal and the second pixel pulse signal are respectively one of a high-gain image pulse signal and a low-gain image pulse signal; and
the counter circuit is configured to:
count one reset pulse signal in the first reset sampling time period to generate one first digital code value;
count another reset pulse signal in the second reset sampling time period to generate another first digital code value;
count the first pixel pulse signal based on the second digital code value and store a counting result as the third digital code value in the first exposure sampling time period; and
count the second pixel pulse signal based on the fourth digital code value and store a counting result as the fifth digital code value in the second exposure sampling time period.

9. The readout circuit of the image sensor according to claim 7 or 8, wherein the counter circuit comprises a first counter unit to an n-th counter unit;
the storage circuit comprises n storage units, the storage units are respectively connected to the counter units in a one-to-one correspondence and to the inversion control circuit;
each of the storage units comprises a first memory, a second memory and a NAND gate;
an input end of the first memory and an input end of the second memory are simultaneously connected to a corresponding counter unit, an output end of the first memory is connected to a first input end of the NAND gate, a second input end of the NAND gate is configured for an input of the write-back control signal, and the NAND gate constitutes an output end of the storage unit;
the first memory is configured to store a corresponding one-bit count value of at least one first digital code value; and
and the first memory and the second memory respectively store a corresponding one-bit count value of one of the third digital code value and the fifth digital code value.

10. The readout circuit of the image sensor according to claim 6, wherein the image sensor comprises a pixel array, each pixel array comprises pixel units arranged in an array, and each readout circuit of the image sensor is connected to a plurality of pixel units arranged in a column, and the pixel unit comprises at least four sub-pixels arranged in a 2×2 manner, wherein at least two sub-pixels constitute a pixel group and are controlled to simultaneously output a reset signal or a pixel signal simultaneously;
the reset sampling time period comprises a first reset sampling time period and a second reset sampling time period following immediately the first reset sampling time period, and the at least one reset pulse signal comprises a high-gain reset pulse signal and a low-gain reset pulse signal;
the first pixel pulse signal comprises a high-gain image pulse signal, and the second pixel pulse signal comprises a low-gain pixel-group pulse signal corresponding to a simultaneous exposure of pixel groups in a low-gain mode and a low-gain image pulse signal corresponding to a simultaneous exposure of sub-pixels in the pixel units under the low-gain mode;
the second exposure sampling time period comprises a third exposure sampling time period and a fourth exposure sampling time period following immediately the third exposure sampling time period;
the first digital code value comprises a first sub-digital code value and a second sub-digital code value;
the counter circuit is configured to:
count the low-gain reset pulse signal in the first reset sampling time period to generate the first sub-digital code value;
count the high-gain reset pulse signal in the second reset sampling time period to generate the second sub-digital code value; and
count the high-gain image pulse signal based on the second digital code value in the first exposure sampling time period, and store a counting result as the third digital code value;
wherein the fifth digital code value comprises a fifth sub-digital code value and a sixth sub-digital code value;
count the low-gain pixel-group pulse signal based on the fourth digital code value in the third exposure sampling time period, and store a counting result as the fifth sub-digital code value; and
count the low-gain image pulse signal based on the fourth digital code value in the fourth exposure sampling time period, and store a counting result as the sixth sub-digital code value;
the storage circuit is connected to the counter circuit and configured to store the first sub-digital code value, and before the third exposure sampling time period and the fourth exposure sampling time period, the storage circuit is further configured, in response to the triggering of the write-back control signal, to write back the first sub-digital code value to the counter circuit; and
the inversion control circuit is connected to the counter circuit and the storage circuit, and before each exposure sampling time period, the inversion control circuit is configured, in response to the triggering of the inversion control signal, to control the counter circuit to invert a stored first sub-digital code value to generate the fourth digital code value, and to invert the second sub-digital code value to generate the second digital code value.

11. The readout circuit of the image sensor according to claim 6, wherein the image sensor comprises a pixel array, each pixel array comprises pixel units arranged in an array, each readout circuit of the image sensor is connected to a plurality of pixel units arranged in a column, the pixel unit comprises four sub-pixels arranged in a 2×2 manner, two sub-pixels constitute a pixel group and are controlled to simultaneously output a reset signal or a pixel signal;
the reset sampling time period comprises a first reset sampling time period and a second reset sampling time period following immediately the first reset sampling time period, and the at least one reset pulse signal comprises a high-gain reset pulse signal and a low-gain reset pulse signal;
the first pixel pulse signal comprises a high-gain pixel-group pulse signal corresponding to a simultaneous exposure of pixel groups in the high-gain mode and a high-gain image pulse signal corresponding to a simultaneous exposure of sub-pixels in the pixel units under the high-gain mode;
the second pixel pulse signal comprises a low-gain image pulse signal;
the first exposure sampling time period comprises a third exposure sampling time period and a fourth exposure sampling time period following immediately the third exposure sampling time period;
the first digital code value comprises a first sub-digital code value and a second sub-digital code value;
the counter circuit is configured to:
count the low-gain reset pulse signal in the first reset sampling time period to generate the first sub-digital code value;
count the high-gain reset pulse signal in the second reset sampling time period to generate the second sub-digital code value;
wherein the third digital code value comprises a third sub-digital code value and a fourth sub-digital code value;
count the high-gain pixel-group pulse signal based on the second digital code value in the third exposure sampling time period, and store a counting result as the third sub-digital code value;
count the high-gain image pulse signal based on the second digital code value in the fourth exposure sampling time period, and store a counting result as the fourth sub-digital code value; and
count the low-gain image pulse signal based on the fourth digital code value in the second exposure sampling time period, and store a counting result as the fifth digital code value;
the storage circuit is connected to the counter circuit and configured to store the first sub-digital code value and the second sub-digital code value, and before the fourth exposure sampling time period and the second exposure sampling time period, the storage circuit is configured, in response to the triggering of the write-back control signal, to write back the second sub-digital code value and the first sub-digital code value to the counter circuit; and
the inversion control circuit is connected to the counter circuit and the storage circuit, before each exposure sampling time period, the inversion control circuit is configured, in response to the triggering of the inversion control signal to control the counter circuit to invert a stored second sub-digital code value to generate the second digital code value, and to invert the first sub-digital code value to generate the fourth digital code value.

12. The readout circuit of the image sensor according to claim 10 or 11, wherein the counter circuit comprises a first counter unit to an n-th counter unit;
the storage circuit comprises n storage units, the storage units are respectively connected to the counter units in a one-to-one correspondence and to the inversion control circuit;
each of the storage units comprises a first memory, a second memory, a third memory, a NAND gate and a first two-to-one data selector;
an input end of the first memory, an input end of the second memory and an input end of the third memory are simultaneously connected to a corresponding counter unit, an output end of the first memory is connected to a first input end of the first two-to-one data selector, an output end of the second memory is connected to s second input end of the first two-to-one data selector is connected, a control end of the first two-to-one data selector is configured for an input of the write-back selection signal, an output end of the first two-to-one data selector is connected to a first input end of the NAND gate, a second input end of the NAND gate is configured for an input of the write-back control signal, and the NAND gate constitutes the output end of the storage circuit;
the first memory is configured to store a corresponding one-bit count value in the first sub-digital code value;
the second memory is configured to store a corresponding one-bit count value in the second sub-digital code value; and
the first memory, the second memory and the third memory are further configured to store a corresponding one-bit count value of three digital code values after three exposure samplings respectively.

13. The readout circuit of the image sensor according to claim 6, wherein the image sensor comprises a pixel array, each pixel array comprises pixel units arranged in an array, each readout circuit of the image sensor is connected to a plurality of pixel units arranged in a column, the pixel unit comprises four sub-pixels arranged in a 2×2 manner, two sub-pixels constitute a pixel group and are controlled to simultaneously output a reset signal or a pixel signal;
the reset sampling time period comprises a first reset sampling time period and a second reset sampling time period, and the at least one reset pulse signal comprises a high-gain reset pulse signal and a low-gain reset pulse signal;
the first pixel pulse signal comprises a first pixel-group pulse signal corresponding to a simultaneous exposure of pixel groups in a high-gain mode and a first image pulse signal corresponding to a simultaneous exposure of sub-pixels in the pixel units under the high-gain mode;
the second pixel pulse signal comprises a second pixel-group pulse signal corresponding to a simultaneous exposure of pixel groups in a low-gain mode and a second image pulse signal corresponding to a simultaneous exposure of the sub-pixels in the pixel units under the low-gain mode;
the first exposure sampling time period comprises a third exposure sampling time period and a fourth exposure sampling time period following immediately the third exposure sampling time period;
the second exposure sampling time period comprises a fifth exposure sampling time period and a sixth exposure sampling time period following immediately the fifth exposure sampling time period;
the first digital code value comprises a first sub-digital code value and a second sub-digital code value;
the counter circuit is configured to:
count the low-gain reset pulse signal in the first reset sampling time period to generate the first sub-digital code value;
count the high-gain reset pulse signal in the second reset sampling time period to generate the second sub-digital code value;
wherein the third digital code value comprises a third sub-digital code value and a fourth sub-digital code value;
count the first pixel-group pulse signal based on the second digital code value in the third exposure sampling time period, and store a counting result as the third sub-digital code value;
count the first image pulse signal based on the second digital code value in the fourth exposure sampling time period, and store a counting result as the fourth sub-digital code value;
wherein the fifth digital code value comprises a fifth sub-digital code value and a sixth sub-digital code value;
count the second pixel-group pulse signal based on the fourth digital code value in the fifth exposure sampling time period, and store a counting result as the fifth sub-digital code value; and
count the second image pulse signal based on the fourth digital code value in the sixth exposure sampling time period, and store a counting result as the sixth sub-digital code value;
the storage circuit is connected to the counter circuit and configured to store the first sub-digital code value and the second sub-digital code value, and before the fourth exposure sampling time period, the storage circuit is configured, in response to the triggering of the write-back control signal, to write back the second sub-digital code value to the counter circuit, and before the fifth exposure sampling time period and the sixth exposure sampling time period, the storage circuit is configured, in response to the triggering of the write-back control signal, to write back the first sub-digital code value to the counter circuit; and
the inversion control circuit is connected to the counter circuit and the storage circuit, and before each exposure sampling time period, the inversion control circuit is configured, in response to the triggering of the inversion control signal, to control the counter circuit to invert a stored second sub-digital code value to generate the second digital code value, and to invert the first sub-digital code value to generate the fourth digital code value.

14. The readout circuit of the image sensor according to claim 13, wherein the counter circuit comprises a first counter unit to an n-th counter unit;
the storage circuit comprises n storage units, the storage units are respectively connected to the counter units in a one-to-one correspondence and to the inversion control circuit;
each of the storage units comprises a first memory, a second memory, a third memory, a fourth memory, a NAND gate and a first two-to-one data selector;
an input end of the first memory, an input end of the second memory and an input end of the third memory are simultaneously connected to a corresponding counter unit, an output end of the first memory is connected to a first input end of the first two-to-one data selector, an output end of the second memory is connected to a second input end of the first two-to-one data selector, a control end of the first two-to-one data selector is configured for an input of the write-back selection signal, an output end of the first two-to-one data selector is connected to a first input end of the NAND gate, a second input end of the NAND gate is configured for an input of the write-back control signal, and the NAND gate constitutes an output end of the storage circuit;
the first memory is configured to store a corresponding one-bit count value of the first sub-digital code value;
the second memory is configured to store the corresponding one-bit count value of the second sub-digital code value;
the first memory, the second memory, the third memory and the fourth memory are further configured store a corresponding one-bit count value of the third sub-digital code value, the fourth sub-digital code value, the fifth sub-digital code value and the sixth sub-digital code value respectively.

15. The readout circuit of the image sensor according to claim 6, wherein the counter circuit comprises a first counter unit to an n-th counter unit;
the inversion control circuit comprises n selection circuits;
a first input end of an i-th selection circuit is configured for an input of the inversion control signal, a second input end of the first selection circuit is configured for an input of the clock signal, second input ends of the second selection circuit to the n-th selection circuit are respectively connected to an output end of the (i-1)-th counter unit, a third input end of the i-th selection circuit is configured for an input of a low-level signal, a fourth input end of the first selection circuit is configured for an input of an output signal of the comparison circuit, an output end of the i-th selection circuit is connected to an input end of an i-th counter unit, wherein i is 1, 2,..n;
the i-th selection circuit is configured, in response to the triggering of the mode selection signal or the write-back control signal, to output signals received at the first input end, the second input end or the third input end of the i-th selection circuit.

16. The readout circuit of the image sensor according to claim 15, wherein the first selection circuit comprises an AND gate, a second two-selection data selector, a third two-selection data selector and a first inverter;
a first input end of the AND gate is configured for an input of the clock signal, a second input end of the AND gate is configured for an input of the output signal of the comparison circuit, a first input end of the second two-selection data selector is configured for an input of the inversion control signal, an output end of the AND gate is connected to a second input end of the two-selection data selector, a second input end of the second two-selection data selector is configured for an input of the low-level signal, a control end of the second two-selection data selector is connected to an output end of the storage circuit, an output end of the second two-selection data selector is connected to a first input end of the third two-selection data selector, a second input end of the third two-selection data selector is configured for an input of the clock signal or a value output from a previous counter unit, a control end of the third two-selection data selector is configured for an input of the mode selection signal, an output end of the third two-selection data selector is connected to an input end of the first inverter, and an output end of the first inverter is configured to output a corresponding one of the inversion control signal, the clock signal and the low-level signal;
the second selection circuit to the n-th selection circuit each comprises a second two-to-one data selector, a third two-to-one data selector and a first inverter; and
a first input end of the second two-to-one data selector is configured for an input of the inversion control signal, a second input end of the second two-to-one data selector is configured for an input of the low-level signal, a control end of the second two-to-one data selector is connected to an output end of the storage circuit, an output end of the second two-to-one data selector is connected to a first input end of the third two-to-one data selector, a second input end of the third two-to-one data selector is configured for an input of the clock signal or the value output from a previous counter unit, a control end of the third two-to-one data selector is configured for an input of the mode selection signal, an output end of the third two-to-one data selector is connected to an input end of the first inverter, and an output end of the first inverter is configured to output a corresponding one of the inversion control signal, the clock signal, the low-level signal and the value output from the previous counter unit.

17. The readout circuit of the image sensor according to claim 3 or 15, wherein the counter unit comprises a D flip-flop and a second inverter;
a clock signal pin of the D flip-flop of the i-th counter unit is connected to a signal output end of the i-th selection circuit, an inverting output pin of the D flip-flop of the i-th counter unit is connected to an input end of the second inverter and a data input pin of the D flip-flop, and an output end of the second inverter is connected to a second input end of an (i+1)-th selection circuit.

18. The readout circuit of the image sensor according to claim 3 or 15, wherein the counter unit comprises a D flip-flop;
a clock signal pin of the D flip-flop of the i-th counter unit is connected to a signal output end of the i-th selection circuit, an inverting output pin of the D flip-flop of the i-th counter unit is connected to a data input pin of the D flip-flop, and a non-inverting output pin of the D flip-flop is connected to a second input end of an (i+1)-th selection circuit.

19. An image sensor, comprising a pixel array, a control circuit and a plurality of readout circuits of the image sensor according to claim 1, wherein the pixel array comprises a plurality of pixel units arranged in an array; and
each readout circuit of the image sensor is connected to a plurality of pixel units arranged in a column, and the readout circuits of the image sensor are further respectively connected to the control circuit.
